# EUROPÄISCHE PATENTSCHRIFT

(11) **EP 2 798 920 B1**
(45) Veröffentlichungstag und Bekanntmachung des Hinweises auf die Patenterteilung: **23.03.2016**
(21) Anmeldenummer: 12816431.6
(22) Anmeldetag: 28.12.2012
(51) Int. Cl.: H05K 3/36, H05K 1/14, H05K 3/40, H05K 3/46

(54) **VERFAHREN ZUM HERSTELLEN EINER AUS WENIGSTENS ZWEI LEITERPLATTENBEREICHEN BESTEHENDEN LEITERPLATTE SOWIE LEITERPLATTE**
METHOD FOR PRODUCING A PRINTED CIRCUIT BOARD CONSISTING OF AT LEAST TWO PRINTED CIRCUIT BOARD REGIONS, AND PRINTED CIRCUIT BOARD
PROCÉDÉ DE FABRICATION D'UNE CARTE À CIRCUIT IMPRIMÉ CONSTITUÉE D'AU MOINS DEUX RÉGIONS, ET CARTE À CIRCUIT IMPRIMÉ AINSI OBTENUE

(30) Priorität: 28.12.2011 AT 6842011
(43) Veröffentlichungstag der Anmeldung: 05.11.2014
(73) Patentinhaber: AT & S Austria Technologie & Systemtechnik Aktiengesellschaft, 8700 Leoben-Hinterberg (AT)
(72) Erfinder: KARPOVYCH, Volodymyr, A-8053 Graz (AT); STAHR, Johannes, AT-8605 St. Lorenzen (AT)
(74) Vertreter: Miksovsky, Alexander
(86) Internationale Anmeldenummer: PCT/AT2012/000325
(87) Internationale Veröffentlichungsnummer: WO 2013/096983

(56) Entgegenhaltungen:
- WO-A1-2008/134809
- JP-A- H10 290 054
- JP-A- 2001 237 551
- US-A1- 2002 117 753

## Beschreibung

Die vorliegende Erfindung bezieht sich auf ein Verfahren zum Herstellen einer aus wenigstens zwei Leiterplattenbereichen bestehenden Leiterplatte, wobei die Leiterplattenbereiche jeweils wenigstens eine leitende Schicht, insbesondere strukturierte leitende Schicht und/oder wenigstens einen Bauteil oder eine leitende Komponente beinhalten, wobei miteinander zu verbindende Leiterplattenbereiche im Bereich von jeweils wenigstens einer unmittelbar aneinander angrenzenden Seitenfläche miteinander durch eine mechanische Kopplung bzw. Verbindung verbunden werden, wobei jeweils wenigstens ein Teilbereich oder Verbindungsanschluss der wenigstens einen leitenden Schicht und/oder ein leitendes Element des Bauteils bzw. der Komponente der miteinander mechanisch verbundenen bzw. zu verbindenden Leiterplattenbereiche an der wenigstens einen aneinander angrenzenden Seitenfläche elektrisch leitend miteinander verbunden bzw. gekoppelt werden. Die vorliegende Erfindung bezieht sich darüber hinaus auf eine Leiterplatte, bestehend aus wenigstens zwei Leiterplattenbereichen, wobei die Leiterplattenbereiche jeweils wenigstens eine leitende Schicht, insbesondere strukturierte leitende Schicht und/oder wenigstens einen Bauteil oder eine leitende Komponente beinhalten, wobei miteinander zu verbindende Leiterplattenbereiche im Bereich von jeweils wenigstens einer unmittelbar aneinander angrenzenden Seitenfläche miteinander durch eine mechanische Kopplung bzw. Verbindung verbunden sind, wobei eine elektrisch leitende Kopplung bzw. Verbindung zwischen wenigstens einem Teilbereich oder Verbindungsanschluss der wenigstens einen leitenden Schicht und/oder einem leitenden Element des Bauteils bzw. der Komponente der miteinander mechanisch verbundenen bzw. zu verbindenden Leiterplattenbereiche an der wenigstens einen aneinander angrenzenden Seitenfläche vorgesehen bzw. ausgebildet ist.

Im Zusammenhang mit der Herstellung von Leiterplatten wird es zunehmend üblich, eine Leiterplatte aus wenigstens zwei insbesondere getrennt voneinander hergestellten Leiterplattenbereichen herzustellen bzw. zusammenzubauen, welche aus in horizontaler Weise verbundenen Bereichen bestehen, die häufig aus unterschiedlichen Materialien hergestellt sind, wobei eine derartige Vorgangsweise, welche beispielsweise als Modularisierung bekannt ist, beispielsweise durchgeführt wird, da einzelne Teilbereiche einer Leiterplatte unterschiedlichen Anforderungen genügen müssen. So ist beispielsweise bekannt, dass in Teilbereichen einer Leiterplatte eine Leistungselektronik integriert bzw. aufgenommen ist, während in anderen Bereichen einer Leiterplatte insbesondere eine Digitaltechnik zur Anwendung gelangt. Eine Herstellung einer Leiterplatte, welche beispielsweise eine Leistungselektronik und gleichzeitig Digitaltechnik enthält, ist vom Herstellungsaufwand und von der Ausführung elektrischer und mechanischer Kopplungen nicht sinnvoll und führt üblicherweise zu erhöhten Kosten. Darüber hinaus werden im Hinblick auf eine zunehmend gewünschte Miniaturisierung von derartigen Leiterplatten zunehmend unterschiedliche Herstellungstechniken bzw. -verfahren angewandt, welche ebenfalls nicht ohne weiteres miteinander kombinierbar sind.

Schließlich weist eine derartige Leiterplatte, welche durch Kopplung von übereinander angeordneten Schichten unterschiedlichen Materials aufgebaut ist, d.h. einen sogenannten Hybridaufbau aufweist, bzw. welche Teilbereiche aufweist, in welche eine Hochfrequenz- oder Leistungselektronik integriert ist, üblicherweise Bereiche unterschiedlicher Erwärmung bzw. unterschiedlicher Ausdehnungskoeffizienten auf, so dass sich im praktischen Einsatz eine derartige Leiterplatte häufig verwirft bzw. verwindet, wodurch ihre Standzeit und Zuverlässigkeit deutlich herabgesetzt ist.

Zur Behebung der obigen Nachteile wurden bereits ein Verfahren sowie eine Leiterplatte der eingangs genannten Art vorgeschlagen, wie dies beispielsweise der WO 2011/003123 A1 entnehmbar ist. Hierbei beinhalten nebeneinander anzuordnende und miteinander zu verbindende Leiterplattenbereiche jeweils wenigstens eine leitende Schicht und/oder wenigstens einen Bauteil oder eine leitende Komponente, wobei eine mechanische Verbindung bzw. Kopplung derartiger, miteinander zu verbindender Leiterplattenbereiche an wenigstens einer aneinander angrenzenden Seitenfläche vorzusehen ist. Während eine wenigstens teilweise mechanische Kopplung bzw. Verbindung derartiger aneinander angrenzender bzw. miteinander zu verbindender Leiterplattenbereiche an der Seitenfläche vorgenommen wird, muss für eine elektrische Kopplung bzw. Verbindung der miteinander zu verbindenden Leiterplattenbereiche wenigstens eine, die Grenzfläche zwischen den zwei miteinander zu verbindenden Leiterplattenbereichen überdeckende Schicht bzw. Lage vorgesehen sein, über welche eine leitende Verbindung zwischen leitenden Teilbereichen bzw. Strukturen und/oder Bauteilen bzw. Komponenten der miteinander zu verbindenden Leiterplattenbereiche vorgenommen wird. Hierzu ist nicht nur eine derartige zusätzliche Schicht erforderlich, welche zu einer Erhöhung der Dicke der herzustellenden Leiterplatte führt, sondern es muss eine elektrische Verbindung über aufwändige Durchbrechungen oder Vias vorgenommen werden. Deren Ausbildung bzw. Anordnung muss insbesondere unter Berücksichtigung der zunehmenden Miniaturisierung nicht nur äußerst präzise und in aufwändigen Verfahrensschritten erfolgen, sondern es muss ihre Anordnung auch bei der Ausbildung der einzelnen Leiterplattenbereiche zur Bereitstellung entsprechender Bereiche für eine elektrische Kontaktierung bzw. Verbindung berücksichtigt werden. Eine derartige Ausbildung führt somit zu einem erhöhten Bearbeitungs- sowie Konstruktionsaufwand und zu einer Vergrößerung der aus den miteinander zu verbindenden Leiterplattenbereichen herzustellenden Leiterplatte.

In ähnlicher Weise wurde gemäß der WO 2008/134809 A1 eine mechanische Kopplung bzw. Verbindung von miteinander zu verbindenden Leiterplatten bzw. Leiterplattenbereichen über formschlüssige komplementäre Profilierungen an der aneinander angrenzenden Seitenfläche vorgeschlagen. Darüber hinaus ist in dieser bekannten Ausführungsform, bei welcher die einzelnen Leiterplattenbereiche jeweils streifenartige LED-Elemente ausbilden, eine elektrische Verbindung bzw. Kopplung jeweils an der Oberseite der miteinander zu verbindenden Leiterplattenbereiche in Eckbereichen der aneinander angrenzenden Seitenflächen vorgesehen.

Ein Verfahren sowie eine Leiterplatte der eingangs genannten Art sind beispielsweise der JP 2001 237551 A1 zu entnehmen, wobei auf eine Festlegungsstruktur für eine mehrlagige Leiterplatte abgezielt wird.

Ähnliche Ausführungsformen sind darüber hinaus der WO 2008/134809 A1, der JP H10 290054 A oder der US 2002/117753 A1 zu entnehmen.

Die vorliegende Erfindung zielt darauf ab, ein Verfahren sowie eine Leiterplatte der eingangs genannten Art dahingehend weiterzubilden, dass die oben erwähnten Nachteile beim Einsatz und Zusammenbau unterschiedlicher und miteinander zu verbindender Leiterplattenbereiche vermieden werden, wobei insbesondere auf eine zuverlässige elektrische Verbindung bzw. Kontaktierung der miteinander zu verbindenden bzw. zu koppelnden Leiterplattenbereiche abgezielt wird, welche beispielsweise unterschiedliche Dicken aufweisen.

Zur Lösung dieser Aufgaben ist ein Verfahren der eingangs genannten Art im Wesentlichen dadurch gekennzeichnet, dass die eine unterschiedliche Höhe bzw. Dicke aufweisenden Leiterplattenbereiche wenigstens auf der unterschiedlich hohe Bereiche aufweisenden Oberfläche mit einem wenigstens eine zu den Leiterplattenbereichen gewandte isolierende Schicht und eine leitende Schicht aufweisenden Laminat unter wenigstens teilweiser Verfüllung des Spalts an den aneinander angrenzenden Seitenflächen laminiert werden und nachfolgend die elektrisch leitende Verbindung von elektrisch leitenden Teilbereichen oder Verbindungsanschlüssen an den aneinander angrenzenden Seitenflächen ausgebildet wird. Da eine elektrisch leitende Verbindung bzw. Kopplung von jeweils wenigstens einem Teilbereich oder Verbindungsanschluss der wenigstens einen leitenden Schicht, insbesondere strukturierten leitenden Schicht oder eines leitenden Elements eines in einem Leiterplattenbereich integrierten Bauteils oder einer Komponente an der wenigstens einen aneinander angrenzenden Seitenfläche vorgenommen wird, kann somit eine unmittelbare, im Wesentlichen laterale elektrische Kopplung bzw. Verbindung neben der vorgesehenen mechanischen Verbindung im Bereich der jeweils aneinander angrenzenden Seitenfläche der miteinander zu verbindenden Leiterplattenbereiche zur Verfügung gestellt werden. Im Gegensatz zum bekannten und oben erwähnten Stand der Technik ist es somit nicht erforderlich, eine derartige elektrische Verbindung bzw. Kopplung über eine Anordnung wenigstens einer zusätzlichen, insbesondere leitenden Schicht über den an der Seitenfläche miteinander verbundenen Leiterplattenbereichen sowie eine aufwändige Durchkontaktierung über Durchbrechungen bzw. Vias vorzusehen. Mit dem erfindungsgemäßen Verfahren gelingt somit neben einer mechanischen Verbindung eine einfache und zuverlässige elektrische Kopplung bzw. Verbindung der miteinander zu verbindenden Leiterplattenbereiche an der jeweils wenigstens einen aneinander angrenzenden Seitenfläche ohne eine Erhöhung der Dicke der herzustellenden Leiterplatte und unter Verzicht auf eine aufwändige Positionierung von entsprechenden elektrischen Kontaktierungen nach einer Anordnung wenigstens einer zusätzlichen leitenden Schicht.

Bei Einsatz unterschiedlicher miteinander zu verbindender Leiterplattenbereiche ist zumindest in einigen Fällen davon auszugehen, dass derartige miteinander zu verbindende Leiterplattenbereiche unterschiedliche Höhe bzw. Dicke aufweisen. Derartige Teilbereiche unterschiedlicher Höhe bzw. Dicke können jedoch zu Problemen bei weiterführenden Be- bzw. Verarbeitungsschritten führen, da derartige weitere Schritte in den meisten Fällen das Vorliegen von im Wesentlichen flächigen und somit keine Teilbereiche unterschiedlicher Höhe aufweisenden Elementen erfordern. Für einen Höhen- bzw. Dickenausgleich bei einer Verbindung bzw. Kopplung von unterschiedliche Höhe aufweisenden Leiterplattenbereichen wird erfindungsgemäß vorgeschlagen, dass die eine unterschiedliche Höhe bzw. Dicke aufweisenden Leiterplattenbereiche wenigstens auf der unterschiedlich hohe Bereiche aufweisenden Oberfläche mit einem wenigstens eine zu den Leiterplattenbereichen gewandte isolierende Schicht und eine leitende Schicht aufweisenden Laminat unter wenigstens teilweiser Verfüllung des Spalts an den aneinander angrenzenden Seitenflächen laminiert werden und nachfolgend die elektrisch leitende Verbindung von elektrisch leitenden Teilbereichen oder Verbindungsanschlüssen an den aneinander angrenzenden Seitenflächen ausgebildet wird. Derart kann nicht nur ein Höhenausgleich von gegebenenfalls unterschiedliche Höhe bzw. Dicke aufweisenden Leiterplattenbereichen erzielt werden, sondern es kann während des Laminierschritts auch eine Verfüllung des Spalts an den zueinander gewandten Seitenflächen zur Erzielung der gewünschten mechanischen Verbindung bzw. Kopplung der miteinander zu verbindenden Leiterplattenbereiche erzielt werden, so dass eine im Wesentlichen kleberfreie Verbindung der Leiterplattenbereiche zur Verfügung gestellt werden kann. Anschließend an eine derartige Laminierung zur Erzielung eines Höhenausgleichs wird, wie dies oben ausgeführt wurde, eine elektrische Kontaktierung bzw. Kopplung zwischen einzelnen Teilbereichen oder Verbindungsanschlüssen an den aneinander angrenzenden Seitenflächen ausgebildet bzw. vorgenommen.

Zur Bereitstellung eines im Wesentlichen symmetrischen Aufbaus und insbesondere zur Vermeidung von gegebenenfalls auftretenden mechanischen einseitigen Belastungen durch Vorsehen eines derartigen Laminats wird gemäß einer bevorzugten Ausführungsform vorgeschlagen, dass die Leiterplattenbereiche auf beiden Oberflächen mit einem mehrlagigen Laminat laminiert werden.

Eine besonders zuverlässige und einfache elektrische Verbindung bzw. Kopplung entsprechender Elemente der miteinander zu verbindenden Leiterplattenbereiche wird gemäß einer bevorzugten Ausführungsform dadurch zur Verfügung gestellt, dass die miteinander zu verbindenden Teilbereiche oder Verbindungsanschlüsse der wenigstens einen leitenden Schicht und/oder des leitenden Elements des Bauteils bzw. der Komponente zur Ausbildung der elektrischen Verbindung durch Anordnung eines leitenden Materials elektrisch miteinander verbunden bzw. gekoppelt werden.

Eine einfach herstellbare elektrisch leitende Verbindung zwischen den miteinander zu verbindenden Leiterplattenbereichen wird darüber hinaus bevorzugt dadurch zur Verfügung gestellt, dass zur Ausbildung der elektrisch leitenden Verbindung ein elektrisch leitendes Metall, wie beispielsweise Kupfer, oder ein wenigstens eine leitende bzw. leitfähige Komponente enthaltendes Material, wie beispielsweise eine Kupfer enthaltende Paste verwendet wird. Der Einsatz eines derartigen leitenden Metalls oder eines eine leitende bzw. leitfähige Komponente enthaltenden Materials ist im Rahmen der Herstellung einer Leiterplatte für sich gesehen bekannt, so dass für die Ausbildung der erfindungsgemäß vorgesehenen, elektrisch leitenden Verbindung an sich bekannte Verfahrensschritte im Rahmen der Herstellung einer Leiterplatte angewandt bzw. eingesetzt werden können.

Zur Bereitstellung einer einfachen und zuverlässigen Kopplung von insbesondere einen unterschiedlichen Aufbau aufweisenden, miteinander zu verbindenden Leiterplattenbereichen ist gemäß einer weiters bevorzugten Ausführungsform vorgesehen, dass elektrisch leitende Schichten in unterschiedlichen Höhen bzw. Ebenen der miteinander zu verbindenden Leiterplattenbereiche leitend miteinander verbunden bzw. gekoppelt werden.

Ebenfalls in Abstimmung auf unterschiedlichen Aufbau bzw. unterschiedliche Strukturen aufweisende, miteinander zu verbindende Leiterplattenbereiche wird darüber hinaus gemäß einer weiters bevorzugten Ausführungsform vorgeschlagen, dass eine unterschiedliche Anzahl von Schichten und/oder nicht aufeinander abgestimmte Schichten miteinander verbunden bzw. gekoppelt wird bzw. werden.

Für eine gegebenenfalls erwünschte Kopplung von in unterschiedlichen Höhen liegenden, miteinander elektrisch zu verbindenden Teilbereichen von leitenden Schichten oder von leitenden Elementen eines in einem Leiterplattenbereich integrierten Bauteils wird darüber hinaus vorgeschlagen, dass die elektrisch leitende Verbindung über einen Teilbereich der Höhe der miteinander zu verbindenden Leiterplattenbereiche ausgebildet wird, wie dies einer weiters bevorzugten Ausführungsform des erfindungsgemäßen Verfahrens entspricht.

Insbesondere unter Berücksichtigung eines üblicherweise komplizierten Aufbaus derartiger miteinander zu verbindender bzw. zu koppelnder Leiterplattenbereiche, welche gegebenenfalls eine Vielzahl von integrierten Bauteilen oder Komponenten enthalten, wird gemäß einer weiters bevorzugten Ausführungsform vorgeschlagen, dass eine Mehrzahl von elektrisch leitenden Verbindungen bzw. Kopplungen voneinander getrennt entlang der wenigstens einen aneinander angrenzenden Seitenfläche der miteinander zu verbindenden Leiterplattenbereiche ausgebildet wird. Unter Einsatz von an sich bekannten Verfahrensschritten bei der Herstellung einer Leiterplatte kann eine derartige Vielzahl von voneinander getrennten Verbindungen bzw. Kopplungen entlang der Seitenfläche für eine elektrisch leitende Verbindung unterschiedlicher Strukturen bzw. Teilbereiche zuverlässig hergestellt werden.

Zur Ausbildung der elektrisch leitenden Verbindungen wird gemäß einer weiters bevorzugten Ausführungsform vorgeschlagen, dass Durchbrechungen oder Hohlräume in dem Spalt zwischen aneinander angrenzenden Seitenflächen zur Ausbildung der elektrisch leitenden Verbindungen durch ein Bohrverfahren, insbesondere ein mechanisches Bohren oder ein Laserbohren, oder durch ein Photoresistverfahren hergestellt werden.

Nach einem Ausbilden derartiger Durchbrechungen oder Hohlräume an der wenigstens einen aneinander angrenzenden Seitenfläche kann die elektrisch leitende Verbindung gemäß einer weiters bevorzugten Ausführungsform des erfindungsgemäßen Verfahrens insbesondere dadurch hergestellt werden, dass die elektrisch leitende Verbindung durch ein Plattieren oder Füllen der Durchbrechungen bzw. Hohlräume mit einem leitenden Metall, insbesondere Kupfer, oder durch eine Anordnung von stiftartigen Elementen aus einem leitenden Material gebildet wird.

Anstelle einer getrennten Ausbildung einer Mehrzahl von mit einem leitenden Material gefüllten bzw. zu füllenden Durchbrechungen zur Herstellung der Kontaktierung unterschiedlicher Teilbereiche oder Verbindungsanschlüsse oder Elemente der miteinander zu verbindenden Leiterplattenbereiche wird gemäß einer abgewandelten Ausführungsform der vorliegenden Erfindung vorgeschlagen, dass der Spalt zwischen aneinander angrenzenden Seitenflächen mit einem leitenden bzw. leitfähigen Material gefüllt wird und dass nach dem Füllen des Spalts mit leitendem bzw. leitfähigem Material Teilbereiche desselben durch eine Ausbildung von Durchbrechungen oder dgl. und gegebenenfalls nachträgliches Füllen mit isolierenden Material zur Ausbildung von voneinander getrennten Kontaktierungen voneinander getrennt werden. Derart wird es in einfacher Weise möglich, den Spalt bzw. Zwischenraum zwischen aneinander angrenzenden Seitenflächen der miteinander zu verbindenden Leiterplattenbereiche mit einem leitenden Material zu füllen, woran anschließend zur Herstellung von voneinander getrennten Teilbereichen oder Kontaktierungen eine Ausbildung von Durchbrechungen vorgenommen wird, welche gegebenenfalls mit einem isolierenden Material verfüllt werden.

Sowohl die Herstellung einer Mehrzahl von leitenden Kontaktierungen nach Ausbildung von entsprechenden Durchbrechungen entsprechend der oben genannten Ausführungsform als auch die Herstellung einer Trennung von leitenden Teilbereichen oder Kontaktierungen entsprechend der letztgenannten Ausführungsform kann beispielsweise durch Aufnahme bzw. Vorsehen von stiftartigen Elementen erfolgen, deren Außenform insbesondere an die Konturen der hergestellten Löcher bzw. Durchbrechungen angepasst ist und beispielsweise kreisförmig, oval, rechtwinkelig oder polygonal ausgebildet ist. Neben einer Erzielung einer elektrischen Kontaktierung bzw. Verbindung durch Anordnung derartiger stiftartiger Elemente kann durch diese auch eine mechanische Verbindung erzielt werden, wenn entsprechende Einsätze oder Stifte verwendet werden, welche beispielsweise durch ein Presspassen in den vorgesehenen Löchern oder Durchbrechungen eingesetzt werden.

Weiters kann in dem Spalt zwischen benachbarten, miteinander zu verbindenden Leiterplattenbereichen auch ein Feststoff-Füllmaterial vorgesehen sein, welches leitend oder nicht-leitend ist, welches an die Konturen des Spalts bzw. Zwischenraums zwischen miteinander zu verbindenden Leiterplattenbereichen angepasst ist und/oder gegebenenfalls aus einer entsprechenden Folie hergestellt ist. Durch Vorsehen eines derartigen Feststoff-Füllmaterials können nachfolgend entsprechende Kontaktierungen oder nicht-leitende Bereiche zwischen den miteinander zu verbindenden Leiterplattenbereichen im Bereich der aneinander angrenzenden bzw. zueinander gewandten Seitenflächen vorgesehen bzw. ausgebildet werden.

Zur Erzielung einer möglichst geringen Gesamtdicke der herzustellenden Leiterplatte und/oder zur Bereitstellung einer im Wesentlichen ebenen bzw. flachen Konstruktion, welche gegebenenfalls in weiteren Herstellungsschritten mit zusätzlichen Schichten bzw. Lagen einer mehrlagigen Leiterplatte versehen wird, wird darüber hinaus vorgeschlagen, dass miteinander zu verbindende Leiterplattenbereiche im Wesentlichen in einer gemeinsamen Ebene angeordnet und miteinander verbunden bzw. gekoppelt werden, wie dies einer weiters bevorzugten Ausführungsform des erfindungsgemäßen Verfahrens entspricht.

Für eine einfache und zuverlässige mechanische Verbindung bzw. Kopplung wird gemäß einer weiters bevorzugten Ausführungsform vorgeschlagen, dass die mechanische Kopplung bzw. Verbindung der miteinander zu verbindenden Leiterplattenbereiche in an sich bekannter Weise durch ein Kleben, Presspassen, Laminieren, Bonden, Schweißen, Löten oder eine galvanische Verbindung vorgenommen wird.

Neben einer endgültigen mechanischen Verbindung bzw. Kopplung kann in einzelnen Fällen eine provisorische mechanische Verbindung bzw. Kopplung zwischen miteinander zu verbindenden Leiterplattenbereichen insbesondere unter Berücksichtigung nachfolgender Verarbeitungsschritte vorgesehen bzw. erforderlich sein. In diesem Zusammenhang wird gemäß einer weiters bevorzugten Ausführungsform vorgeschlagen, dass eine provisorische mechanische Kopplung bzw. Verbindung der miteinander zu verbindenden Leiterplattenbereiche durch eine Verwendung eines Füllmaterials, durch ein Kleben, durch ein Presspassen, durch Verwendung eines Trägers, wie beispielsweise eines anhaftenden Bands, oder dgl. durchgeführt wird.

Zur Unterstützung der mechanischen Verbindung bzw. Kopplung bzw. zur Bereitstellung einer gegenüber äußeren Beanspruchungen widerstandsfähigen mechanischen Verbindung wird darüber hinaus vorgeschlagen, dass an aneinander angrenzenden Seitenflächen der miteinander zu verbindenden Leiterplattenbereiche in an sich bekannter Weise jeweils wenigstens ein zueinander komplementäres Kopplungselement ausgebildet wird, über welches eine Kopplung bzw. Verbindung mit dem jeweils angrenzenden Leiterplattenbereich vorgenommen wird, wie dies einer weiters bevorzugten Ausführungsform des erfindungsgemäßen Verfahrens entspricht.

Zur weiteren Unterstützung der mechanischen Kopplung bzw. Verbindung der miteinander zu verbindenden Leiterplattenbereiche wird darüber hinaus bevorzugt vorgeschlagen, dass zueinander komplementäre Kopplungselemente formschlüssig miteinander verbunden werden.

Zur Erzielung einer gewünschten mechanischen Kopplung bzw. Verbindung wird gemäß einer weiters bevorzugten Ausführungsform vorgeschlagen, dass die mechanische Kopplung bzw. Verbindung durch Verwendung eines Klebers im Bereich der zueinander komplementären Kopplungselemente ausgebildet wird. Dadurch kann sichergestellt werden, dass ein im Wesentlichen blasenfreies Einbringen des Klebers zur Erzielung der gewünschten mechanischen Verbindung bzw. Kopplung erzielbar ist.

Das erfindungsgemäße Verfahren lässt sich für Leiterplatten bzw. Leiterplattenbereiche unterschiedlichsten Aufbaus sowie unterschiedlicher Struktur einsetzen, wobei gemäß einer weiters bevorzugten Ausführungsform des erfindungsgemäßen Verfahrens vorgesehen ist, dass die miteinander zu verbindenden Leiterplattenbereiche in an sich bekannter Weise von flexiblen, starren, starr-flexiblen oder semi-flexiblen Leiterplattenbereichen und/oder funktionell unterschiedlichen Materialien, beinhaltend Hochfrequenz-, HDI-, Substrat-, oder keramischen Leiterplattenbereichen gebildet werden.

Zur Lösung der oben genannten Aufgaben ist darüber hinaus eine Leiterplatte der eingangs genannten Art im Wesentlichen dadurch gekennzeichnet, dass die eine unterschiedliche Höhe bzw. Dicke aufweisenden Leiterplattenbereiche wenigstens auf der unterschiedlich hohe Bereiche aufweisenden Oberfläche mit einem wenigstens eine zu den Leiterplattenbereichen gewandte isolierende Schicht und eine leitende Schicht aufweisenden Laminat unter wenigstens teilweiser Verfüllung des Spalts an den aneinander angrenzenden Seitenflächen laminiert sind. Wie bereits oben ausgeführt, gelingt eine im Wesentlichen laterale elektrische Kopplung bzw. Verbindung der miteinander zu verbindenden Leiterplattenbereiche an der jeweils wenigstens einen aneinander angrenzenden Seitenfläche, so dass insbesondere auf zusätzliche Schichten bzw. Lagen, welche die Grenzfläche bzw. den Verbindungsbereich zwischen den miteinander zu verbindenden Leiterplattenbereichen überdecken, wie dies im bekannten Stand der Technik vorgesehen war, verzichtet werden kann.

Da miteinander zu verbindende Leiterplattenbereiche in vielen Fällen eine unterschiedliche Höhe bzw. Dicke aufweisen, wird zur Erzielung eines entsprechenden Höhenausgleichs zur Bereitstellung eines Elements mit eine einheitliche Dicke bzw. Höhe aufweisenden Abmessungen erfindungsgemäß vorgeschlagen, dass die eine unterschiedliche Höhe bzw. Dicke aufweisenden Leiterplattenbereiche wenigstens auf der unterschiedlich hohe Bereiche aufweisenden Oberfläche mit einem wenigstens eine zu den Leiterplattenbereichen gewandte isolierende Schicht und eine leitende Schicht aufweisenden Laminat unter wenigstens teilweiser Verfüllung des Spalts an den aneinander angrenzenden Seitenflächen laminiert sind.

Zur Bereitstellung eines im Wesentlichen symmetrischen Aufbaus bei Verwendung eines derartigen Laminats wird gemäß einer weiters bevorzugten Ausführungsform vorgeschlagen, dass die Leiterplattenbereiche auf beiden Oberflächen mit einem mehrlagigen Laminat laminiert sind.

Für eine einfache und zuverlässige Ausbildung der elektrischen Verbindung wird gemäß einer bevorzugten Ausführungsform vorgeschlagen, dass zur Ausbildung der elektrischen Verbindung ein leitendes Material im Bereich der miteinander zu verbindenden Teilbereiche oder Verbindungsanschlüsse der wenigstens einen leitenden Schicht und/oder des leitenden Elements des Bauteils bzw. der Komponente vorgesehen ist.

In diesem Zusammenhang wird gemäß einer weiters bevorzugten Ausführungsform vorgeschlagen, dass zur Ausbildung der elektrisch leitenden Verbindung ein elektrisch leitendes Metall, wie beispielsweise Kupfer, oder ein wenigstens eine leitende bzw. leitfähige Komponente enthaltendes Material, wie beispielsweise eine Kupfer enthaltende Paste vorgesehen ist. Derart kann mit bei einer Herstellung einer Leiterplatte üblicherweise verwendeten Materialien unmittelbar die elektrische Verbindung im Bereich der aneinander angrenzenden Seitenfläche ausgebildet bzw. zur Verfügung gestellt werden.

Für eine Verbindung von miteinander zu verbindenden Leiterplattenbereichen unterschiedlicher Struktur bzw. unterschiedlichen Aufbaus ist gemäß einer weiters bevorzugten Ausführungsform vorgesehen, dass elektrisch leitende Schichten in unterschiedlichen Höhen bzw. Ebenen der miteinander zu verbindenden Leiterplattenbereiche leitend miteinander verbunden bzw. gekoppelt sind.

Ebenfalls zur Anpassung an unterschiedliche Strukturen oder Konstruktionen von miteinander zu verbindenden Leiterplattenbereichen wird gemäß einer weiters bevorzugten Ausführungsform vorgeschlagen, dass eine unterschiedliche Anzahl von Schichten und/oder nicht aufeinander abgestimmte Schichten miteinander verbunden bzw. gekoppelt ist bzw. sind.

Insbesondere zur Kontaktierung bzw. elektrischen Verbindung von in unterschiedlichen Höhen der Dicke der miteinander zu verbindenden Leiterpfattenbereiche vorgesehenen leitenden Strukturen oder leitenden Elementen von integrierten Bauteilen oder Komponenten wird darüber hinaus vorgeschlagen, dass die elektrisch leitende Verbindung über einen Teilbereich der Höhe der miteinander zu verbindenden Leiterplattenbereiche ausgebildet ist, wie dies einer weiters bevorzugten Ausführungsform der erfindungsgemäßen Leiterplatte entspricht.

Insbesondere unter Berücksichtigung der üblicherweise komplexen Struktur derartiger miteinander zu verbindender Leiterplattenbereiche, welche über eine Vielzahl von Kontaktierungen bzw. Kontaktstellen verfügen, wird gemäß einer weiters bevorzugten Ausführungsform vorgeschlagen, dass eine Mehrzahl von elektrisch leitenden Verbindungen bzw. Kopplungen voneinander getrennt entlang der wenigstens einen aneinander angrenzenden Seitenfläche der miteinander zu verbindenden Leiterplattenbereiche ausgebildet ist.

Für eine besonderes einfache und zuverlässige Ausbildung sowie Positionierung der herzustellenden elektrischen Verbindungen wird gemäß einer weiters bevorzugten Ausführungsform vorgeschlagen, dass Durchbrechungen oder Hohlräume in dem Spalt zwischen aneinander angrenzenden Seitenflächen zur Ausbildung der elektrisch leitenden Verbindungen oder zur Trennung von elektrisch leitenden Teilbereichen bzw. Kontaktierungen vorgesehen sind.

In diesem Zusammenhang wird gemäß einer weiters bevorzugten Ausführungsform vorgeschlagen, dass die elektrisch leitende Verbindung durch ein Plattieren oder Füllen der Durchbrechungen bzw. Hohlräume mit einem leitenden Metall, insbesondere Kupfer, oder durch stiftartige Elemente aus einem leitenden Material gebildet ist. Derartige Plattierungen sind im Zusammenhang mit einer Herstellung einer Leiterplatte für sich gesehen üblich bzw. bekannt, so dass insbesondere keine zusätzlichen Verfahrensschritte bei der Herstellung einer erfindungsgemäßen Leiterplatte vorzusehen sind. Weiters ist eine Verwendung von stiftartigen Elementen aus einem leitenden Material in einfacher Weise möglich.

Zur Bereitstellung einer Leiterplatte mit insgesamt geringer Höhe und/oder einer im Wesentlichen ebenen bzw. flachen Struktur, auf welcher gegebenenfalls erforderliche weitere Schichten bzw. Lagen einer mehrlagigen Leiterplatte vorgesehen werden können, wird gemäß einer weiters bevorzugten Ausführungsform vorgeschlagen, dass miteinander zu verbindende Leiterplattenbereiche im Wesentlichen in einer gemeinsamen Ebene angeordnet und miteinander verbunden bzw. gekoppelt sind.

Eine zuverlässige mechanische Verbindung bzw. Kopplung wird beispielsweise dadurch zur Verfügung gestellt, dass die mechanische Kopplung bzw. Verbindung der miteinander zu verbindenden Leiterplattenbereiche in an sich bekannter Weise durch ein Kleben, Presspassen, Laminieren, Bonden, Schweißen, Löten oder eine galvanische Verbindung ausgebildet ist, wie dies einer weiters bevorzugten Ausführungsform der erfindungsgemäßen Leiterplatte entspricht.

Zur Bereitstellung einer provisorischen mechanischen Kopplung wird gemäß einer bevorzugten Ausführungsform vorgeschlagen, dass eine provisorische mechanische Kopplung bzw. Verbindung der miteinander zu verbindenden Leiterplattenbereiche durch eine Verwendung eines Füllmaterials, durch ein Kleben, durch ein Presspassen, durch Verwendung eines Trägers, wie beispielsweise eines anhaftenden Bands, oder dgl. vorgesehen ist.

Zur Unterstützung der mechanischen Kopplung bzw. Verbindung wird darüber hinaus bevorzugt vorgeschlagen, dass an aneinander angrenzenden Seitenflächen der miteinander zu verbindenden Leiterplattenbereiche in an sich bekannter Weise jeweils wenigstens ein zueinander komplementäres Kopplungselement vorgesehen ist, über welches eine Kopplung bzw. Verbindung mit dem jeweils angrenzenden Leiterplattenbereich ausgebildet ist.

Zur weiteren Verbesserung der mechanischen Kopplung ist darüber hinaus bevorzugt vorgesehen, dass zueinander komplementäre Kopplungselemente formschlüssig miteinander verbindbar sind.

Zur Erzielung einer besonders zuverlässigen mechanischen Kopplung wird gemäß einer weiters bevorzugten Ausführungsform vorgesehen, dass die mechanische Kopplung bzw. Verbindung durch Verwendung eines Klebers im Bereich der zueinander komplementären Kopplungselemente ausgebildet ist.

Wie bereits oben erwähnt, gelingt erfindungsgemäß eine Kopplung bzw. Verbindung von Leiterplattenbereichen unterschiedlichen Aufbaus sowie unterschiedlicher Struktur, wobei in diesem Zusammenhang gemäß einer weiters bevorzugten Ausführungsform vorgeschlagen wird, dass die miteinander zu verbindenden Leiterplattenbereiche in an sich bekannter Weise von flexiblen, starren, starr-flexiblen oder semi-flexiblen Leiterplattenbereichen und/oder funktionell unterschiedlichen Materialien, beinhaltend Hochfrequenz-, HDI-, Substrat-, oder keramischen Leiterplattenbereichen gebildet sind.

Für eine einfache Positionierung sowie Ausrichtung bei der Kopplung bzw. Verbindung von miteinander zu verbindenden Leiterplattenbereichen wird darüber hinaus vorgeschlagen, dass die miteinander zu verbindenden Leiterplattenbereiche mit wenigstens einer Markierung, insbesondere einem Stift oder dgl. zur Registrierung bei der Verbindung miteinander ausgebildet sind, wie dies einer weiters bevorzugten Ausführungsform der erfindungsgemäßen Leiterplatte entspricht.

Die Erfindung wird nachfolgend anhand von in der beiliegenden Zeichnung schematisch dargestellten Ausführungsbeispielen näher erörtert. In dieser zeigen:
Fig. 1 schematische Darstellungen von Ausführungsformen gemäß dem Stand der Technik, wobei Fig. 1a eine Ausbildung zeigt, bei welcher für eine elektrische Verbindung die miteinander zu verbindenden Leiterplattenbereiche durch weitere Schichten bzw. Lagen abgedeckt sind, und gemäß Fig. 1b im Bereich der Verbindung von benachbarten Leiterplattenbereichen zusätzliche Bauelemente für eine elektrische Verbindung vorgesehen sind;
Fig. 2 eine schematische Draufsicht auf eine beispielhafte Leiterplatte, wobei eine Mehrzahl von elektrischen Verbindungen bzw. Kopplungen im Bereich der Seitenflächen von aneinander angrenzenden Leiterplattenbereichen vorgesehen ist;
Fig. 3 schematische Schnittansichten von unterschiedlichen Ausbildungen einer elektrischen Verbindung zwischen benachbarten Leiterplattenbereichen;
Fig. 4 schematische Draufsichten auf unterschiedliche Ausbildungen von elektrischen Verbindungen einer Leiterplatte;
Fig. 5 in einer zu Fig. 4 ähnlichen Darstellung Draufsichten auf unterschiedliche geometrische Formgebungen der Verbindung bzw. Kopplung von miteinander zu verbindenden Leiterplattenbereichen einer Leiterplatte;
Fig. 6 in einer zu Fig. 4 und Fig. 5 ähnlichen Darstellung weitere Draufsichten auf unterschiedliche Ausbildungen von elektrischen Verbindungen einer Leiterplatte im Bereich der Seitenflächen von aneinander angrenzenden Leiterplattenbereichen;
Fig. 7 in vergrößertem Maßstab einen Teilschnitt durch eine Leiterplatte, wobei insbesondere deutlich ersichtlich ist, dass die miteinander zu verbindenden Leiterplattenbereiche eine Mehrzahl von insbesondere in unterschiedlichen Höhen liegenden Schichten bzw. Lagen aufweisen;
Fig. 8 schematische Darstellungen von elektrischen Verbindungen unterschiedlicher Schichten bzw. Lagen der Ausführungsform gemäß Fig. 7, wobei durch Anordnung einer Mehrzahl von elektrischen Verbindungs- bzw. Kontaktstellen bzw. -bereichen unterschiedliche Teilbereiche von jeweils leitenden Strukturen benachbarter Leiterplattenbereiche in unterschiedlichen Höhenlagen miteinander elektrisch verbindbar bzw. koppelbar sind;
Fig. 9 in einer zu Fig. 5d ähnlichen Darstellung eine abgewandelte Ausführungsform einer Kopplung zwischen miteinander zu verbindenden Leiterplattenbereiche; und

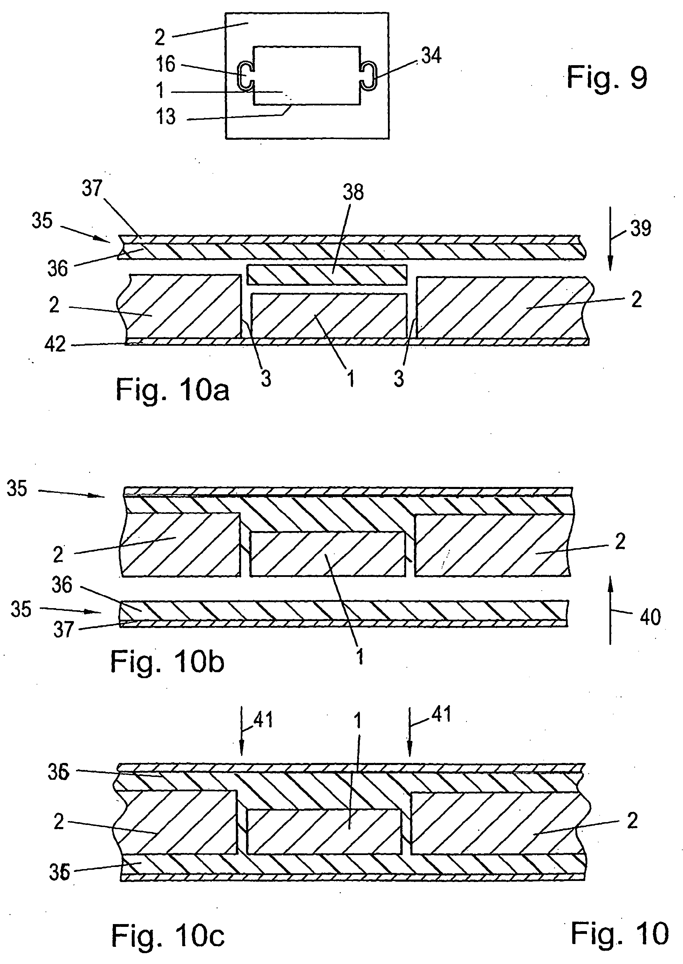

Fig. 10 schematische Darstellungen einer Ausführungsform des erfindungsgemäßen Verfahrens, wobei insbesondere zum Höhenausgleich von unterschiedliche Höhe bzw. Dicke aufweisenden, miteinander zu verbindenden Leiterplattenbereiche eine Laminierung mit einem mehrlagigen Laminat erfolgt, wobei in Fig. 10a der Schritt einer Laminierung mit einem mehrlagigen Laminat auf einer Seite bzw. Oberfläche der miteinander zu verbindenden Leiterplattenbereiche dargestellt wird, in Fig. 10b ein nachfolgender Verfahrensschritt eines Laminierens auf der zweiten Oberfläche der miteinander zu verbindenden Leiterplattenbereiche dargestellt wird und in Fig. 10c die nachträgliche Ausbildung von elektrisch leitenden Verbindungen im Bereich der aneinander angrenzenden Seitenflächen der miteinander zu verbindenden Leiterplattenbereiche gezeigt wird.

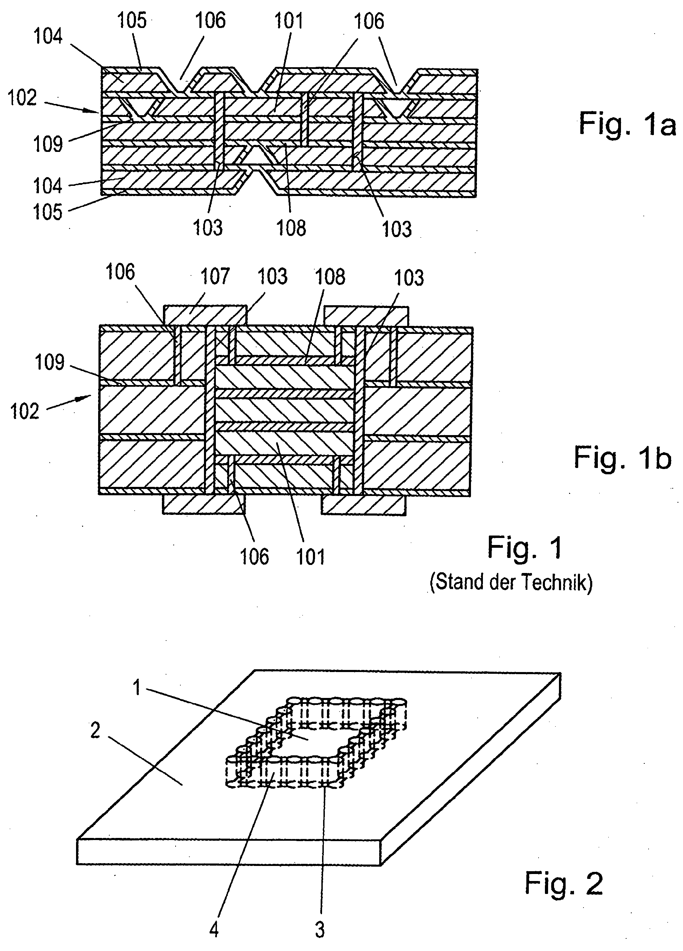

In Fig. 1a und 1b ist jeweils ein insbesondere mehrlagiger Leiterplattenbereich 101 gemäß dem Stand der Technik dargestellt, welcher von einem den Leiterplattenbereich 101 umgebenden weiteren, ebenfalls mehrlagigen Leiterplattenbereich 102 umschlossen ist, wobei eine nicht näher dargestellte mechanische Verbindung bzw. Kopplung zwischen den Leiterplattenbereichen 101 und 102 im Bereich von aneinander angrenzenden Seitenflächen 103 vorgenommen wird. Neben der im Bereich der aneinander angrenzenden Seitenflächen 103 vorzusehenden, nicht näher dargestellten mechanischen Verbindung bzw. Kopplung zwischen den miteinander zu verbindenden Leiterplattenbereichen 101, 102 ist für eine darüber hinaus vorzusehende bzw. erforderliche elektrische Verbindung bzw. Kopplung bei der Ausführungsform gemäß Fig. 1a ersichtlich, dass zusätzliche Schichten bzw. Lagen 104, 105 vorgesehen sind. Eine elektrische Kontaktierung zu den zusätzlichen Lagen 105 und wenigstens einer leitenden Schicht bzw. Lage 108, 109 der Leiterplattenbereiche 101, 102 erfolgt über schematisch angedeutete Vias 106.

Anstelle eines Vorsehens von zusätzlichen Schichten bzw. Lagen für eine elektrische Verbindung bzw. Kontaktierung ist bei der Ausführungsform gemäß dem bekannten Stand der Technik entsprechend Fig. 1b vorgesehen, dass im Bereich der zueinander gewandten Seitenflächen 103 und diese wenigstens teilweise überdeckend zusätzliche Bauteile 107 vorgesehen sind, wobei eine elektrische Kontaktierung wiederum durch Vias 106 angedeutet ist.

Aus den Darstellungen gemäß Fig. 1 ist somit ersichtlich, dass für eine elektrische Verbindung bzw. Kopplung von leitenden Strukturen 108, 109 der miteinander zu verbindenden bzw. zu koppelnden Leiterplattenbereiche 101, 102 zusätzliche Schichten bzw. Lagen 104 und 105 bzw. zusätzliche Bauteile 107 vorzusehen sind.

Im Gegensatz dazu ist bei dem in Fig. 2 dargestellten Beispiel vorgesehen, dass für eine elektrisch leitende Verbindung bzw. Kopplung zwischen einem Leiterplattenbereich 1 und einem diesen umgebenden Leiterplattenbereich 2 im Bereich der jeweils aneinander angrenzenden Seitenflächen 3 eine Mehrzahl von elektrischen Verbindungen bzw. Kopplungen 4 vorgesehen ist, wie dies nachfolgend noch im Detail erörtert werden wird.

Durch Vorsehen derartiger elektrischer Verbindungen bzw. Kopplungen im Bereich der aneinander angrenzenden Seitenflächen 3 wird eine laterale elektrische Kopplung bzw. Verbindung zwischen den miteinander zu verbindenden Leiterplattenbereichen 1 und 2 bzw. leitenden Strukturen derselben erzielbar, wobei auf ein Vorsehen von zusätzlichen Schichten bzw. Lagen oder die aneinander angrenzenden Seitenflächen 3 überdeckenden Bauteilen, wie dies bei dem Stand der Technik gemäß Fig. 1 erforderlich war, verzichtet werden kann.

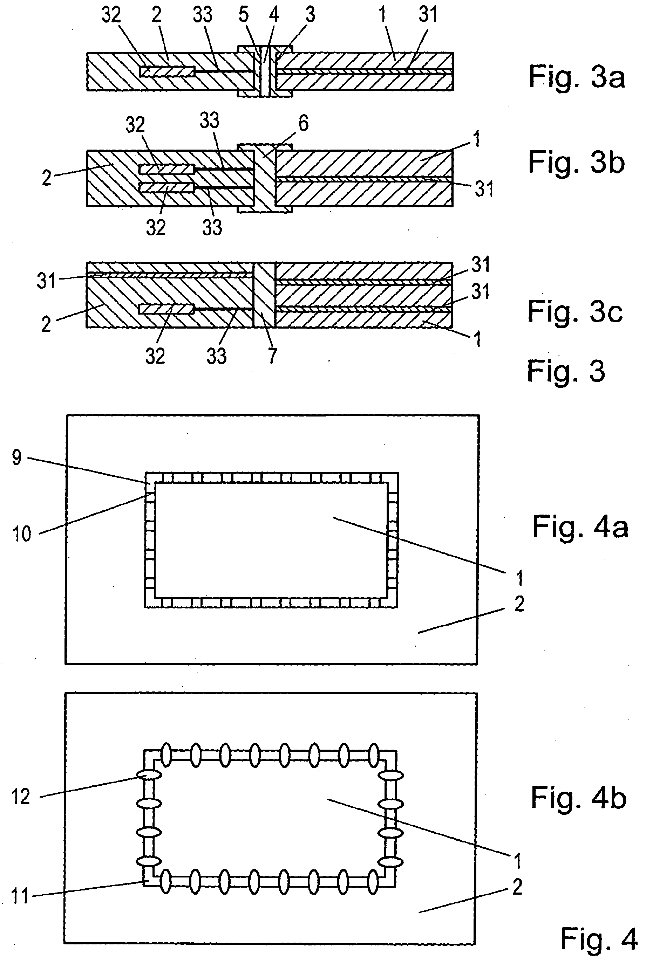

In Fig. 3 sind unterschiedliche Ausführungsformen einer derartigen elektrischen Verbindung bzw. Kopplung zwischen wiederum mit 1 und 2 bezeichneten Leiterplattenbereichen angedeutet. Während mit 31 jeweils wenigstens eine leitende Schicht im Leiterplattenbereich 1 angedeutet ist, ist im Leiterplattenbereich 2 jeweils ein Bauteil 32 integriert, wobei ein leitendes Element bzw. ein Anschluss desselben mit 33 angedeutet ist.

Bei der Ausführungsform gemäß Fig. 3a ist ein im Bereich der Seitenflächen 3 vorgesehener Schlitz bzw. eine Durchbrechung 4 mit einer beispielsweise aus Kupfer bestehenden Plattierung 5 versehen, über welche eine Kontaktierung einer nicht näher dargestellten leitenden Struktur der wenigstens einen leitenden Schicht 31 mit dem leitenden Element 33 des in den Leiterplattenbereich 2 integrierten Bauteils 32 vorgenommen wird.

Anstelle einer derartigen Plattierung 5, wie sie in Fig. 3a dargestellt ist, ist bei der Ausführungsform gemäß Fig. 3b vorgesehen, dass eine derartige Durchbrechung bzw. ein derartiger Schlitz 4 im Wesentlichen vollständig mit einem leitenden Material 6 zur Herstellung einer leitenden Verbindung verfüllt wird. Ein derartiges leitendes Material kann beispielsweise von Kupfer oder einem anderen elektrisch leitenden bzw. leitfähigen Material, insbesondere Metall gebildet sein.

Bei der Ausführungsform gemäß Fig. 3c ist wiederum ein im Wesentlichen vollständiges Verfüllen eines Spalts bzw. einer Durchbrechung 4 zwischen den zu verbindenden elektrischen Strukturen 31, 32 und 33 in den Leiterplattenbereichen 1 und 2 vorgesehen, wobei bei dieser Ausführungsform beispielsweise ein entsprechender Hohlraum bzw. eine Durchbrechung mit einem ein leitfähiges Material, beispielsweise eine Kupferpaste enthaltenden Material 7 verfüllt wird. Ein derartiges pastenförmiges, leitfähiges Material 7 kann zur Herstellung einer entsprechenden Verbindung entsprechend ausgehärtet werden.

Anstelle von oder zusätzlich zu Kupfer können andere leitende bzw. leitfähige Materialien oder Metalle verwendet werden.

Aus den Darstellungen gemäß Fig. 3b und 3c ist darüber hinaus ersichtlich, dass beispielsweise die leitenden Schichten bzw. Lagen 31 als auch die integrierten Elemente bzw. Bauteile 32 sowie deren Anschlüsse bzw. leitenden Elemente 33 in unterschiedlichen Höhen in den miteinander zu verbindenden Leiterplattenbereichen 1 und 2 vorgesehen bzw. angeordnet sind. Weiters ist in der Ausführungsform gemäß Fig. 3c angedeutet, dass auch im Leiterplattenbereich 2 eine wiederum mit 31 bezeichnete leitende Schicht vorgesehen ist.

Anstelle eines Plattierens oder Verfüllens des Spalts bzw. Zwischenraums oder einer Durchbrechung 4 zwischen den miteinander zu verbindenden Leiterplattenbereichen 1 und 2 können auch in diesen Spalt 4 oder entsprechende Bohrungen oder Durch-brechungen stiftartige Elemente eingesetzt werden, deren Außenform beispielsweise den Konturen des Spalts oder einer Durchbrechung zwischen den miteinander zu verbindenden Leiterplattenbereichen 1 und 2 entspricht.

Die Verbindungen 5, 6 bzw. 7 zwischen den miteinander zu verbindenden Leiterplattenbereichen 1 und 2, welche eine elektrische Kontaktierung zwischen miteinander zu verbindenden Teilbereichen bzw. Verbindungsanschlüssen der leitenden Schichten 31, welche insbesondere von strukturierten leitenden Schichten gebildet sind, als auch den Anschlusselementen 33 der integrierten Bauteile 32 darstellen, können neben einer elektrischen auch eine entsprechende mechanische Kopplung bzw. Verbindung zwischen den miteinander zu verbindenden Leiterplattenbereichen 1 und 2 zur Verfügung stellen.

Die Ausbildung entsprechend der Hohlräume bzw. Durchbrechungen 4 im Bereich der aneinander angrenzenden Seitenflächen 3 von miteinander zu verbindenden Leiterplattenbereichen 1 und 2 kann durch ein Bohren, beispielsweise mechanisches Bohren oder ein Laserbohren, ein Schneiden, insbesondere Laserschneiden oder dgl. ausgebildet werden.

Bei der Darstellung gemäß Fig. 4 erfolgt eine Ausbildung einer Mehrzahl von voneinander getrennten Durchbrechungen zur Herstellung einer elektrisch leitenden Verbindung zwischen wiederum mit 1 und 2 bezeichneten Leiterplattenbereichen gemäß der Ausführungsform von Fig. 4a unter Einsatz eines Photoresist-Verfahrens. Hierbei wird in dem im Wesentlichen über den gesamten Umfang des einzubettenden Leiterplattenbereichs 1 vorgesehenen Spalt ein Photoresist eingebracht, worauf nach einem Härten eine Belichtung erfolgt und für eine nachfolgende elektrische Verbindung erforderliche Hohlräume bzw. Durchbrechungen durch ein Auswaschen des Photoresists in einem belichteten bzw. nicht belichteten Bereich in Abhängigkeit von dem verwendeten Photoresist-Material erzeugt werden. Derartige verbleibende Bereiche des Photoresist-Materials sind in Fig. 4a mit 9 bezeichnet, während dazwischen liegende Freiräume bzw. Hohlräume 10 in weiterer Folge mit einem eine leitende Verbindung herstellenden Material wenigstens teilweise verfüllt werden, wie dies beispielsweise unter Bezugnahme auf Fig. 3 erörtert wurde.

Alternativ kann der einen einzubettenden Leiterplattenbereich 1 umgebende Spalt im Wesentlichen vollständig mit einem leitenden Material 11 verfüllt werden, wie dies bei der Darstellung gemäß Fig. 4b ersichtlich ist. Für eine Unterteilung in voneinander getrennte elektrische Verbindungen zum Koppeln unterschiedlicher elektrischer Strukturen in den miteinander zu verbindenden Leiterplattenbereichen 1 und 2 sind bei der Ausbildung gemäß Fig. 4b im Wesentlichen quer zu dem durch die angrenzenden Seitenflächen begrenzten Schlitz verlaufende Hohlräume bzw. Schlitze 12 vorgesehen, welche dazwischen liegende leitende Bereiche 11 trennen, um einzelne leitende bzw. leitfähige Verbindungen zur Verfügung zu stellen. In diese Schlitze bzw. Hohlräume 12 kann beispielsweise ein nicht-leitendes Material eingebracht werden oder es können stiftartige Elemente aus nicht-leitendem Material eingebracht werden.

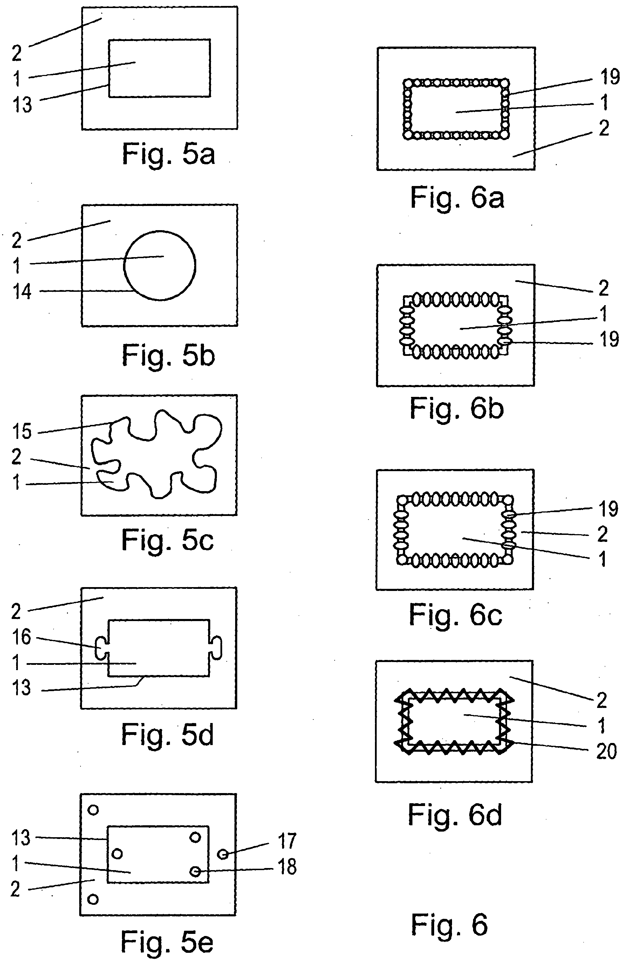

In Fig. 5 sind unterschiedliche Ausführungsformen von möglichen geometrischen Ausbildungen bzw. Anordnungen von elektrisch leitenden Verbindungen jeweils im Bereich von aneinander angrenzenden Seitenflächen von miteinander zu verbindenden Leiterplattenbereichen 1 und 2 dargestellt. So erfolgt bei den Ausführungsformen gemäß Fig. 5a, 5b und 5c eine elektrisch leitende Verbindung entlang von unterschiedlichen Konturen zwischen den miteinander zu verbindenden Leiterplattenbereichen 1 und 2, wobei in Fig. 5a eine im Wesentlichen rechteckige Kontur 13 dargestellt ist. Demgegenüber ist bei der Ausbildung gemäß Fig. 5b eine im Wesentlichen kreisrunde Kontur 14 vorgesehen, während bei der Ausführungsform gemäß Fig. 5c eine Kontur 15 mit unregelmäßigen Abmessungen vorgesehen ist.

Bei der Ausbildung gemäß Fig. 5d ist darüber hinaus ersichtlich, dass insbesondere zur Unterstützung einer mechanischen Verbindung bzw. Kopplung zwischen den Leiterplattenbereichen 1 und 2 zueinander komplementäre Fortsätze bzw. Profilierungen 16 vorgesehen sind, welche ein im Wesentlichen formschlüssiges mechanisches Koppeln zwischen den Leiterplattenbereichen 1 und 2 ermöglichen.

Darüber hinaus ist bei der Ausführungsform gemäß Fig. 5e angedeutet, dass insbesondere für ein entsprechendes korrektes Positionieren der miteinander zu verbindenden Leiterplattenbereiche 1 und 2 Markierungen 17 und 18 für eine Positionierung an den Leiterplattenbereichen 1 und 2 vorgesehen sind.

Trotz der durchgehenden Kontur der Verbindungen 13 bis 15 der Fig. 5a bis 5e kann ähnlich wie bei der Ausbildung gemäß Fig. 4 eine Unterteilung in voneinander getrennte elektrische Verbindungen vorgesehen sein.

Ähnlich wie bei den Darstellungen insbesondere gemäß Fig. 2 und Fig. 4b sind bei den Ausführungsformen gemäß Fig. 6a bis 6d jeweils Ausbildungen gezeigt, welche eine Vielzahl von allgemein mit 19 bezeichneten und voneinander getrennten elektrischen Verbindungen entlang der aneinander angrenzenden Seitenflächen der miteinander zu verbindenden Leiterplattenbereiche 1 und 2 aufweisen. Die Hohlräume bzw. Durchbrechungen, an welchen in weiterer Folge beispielsweise ähnlich den Ausführungsformen gemäß Fig. 3 die elektrisch leitenden Verbindungen 19 bei den Ausführungsformen gemäß Fig. 6a bis 6d hergestellt werden, können wiederum beispielsweise durch ein Bohren von Löchern oder eine Ausbildung von entsprechenden Schlitzen ausgebildet werden.

Bei der Darstellung gemäß Fig. 6d ist darüber hinaus ersichtlich, dass eine im Wesentlichen durchgehende elektrische Verbindung 20 zwischen nicht näher dargestellten elektrisch leitenden Teilbereichen der Leiterplattenbereiche 1 und 2 eine teilweise unregelmäßige Kontur aufweist.

Anstelle der in Fig. 6d dargestellten unregelmäßigen Kontur kann eine entsprechende Verzahnung von aneinander angrenzenden Seitenflächen der miteinander zu verbindenden Leiterplattenbereiche 1, 2 nach Art von zinnenartigen Erhebungen bzw. Fortsätzen und komplementären Vertiefungen bzw. Ausnehmungen vorgesehen sein.

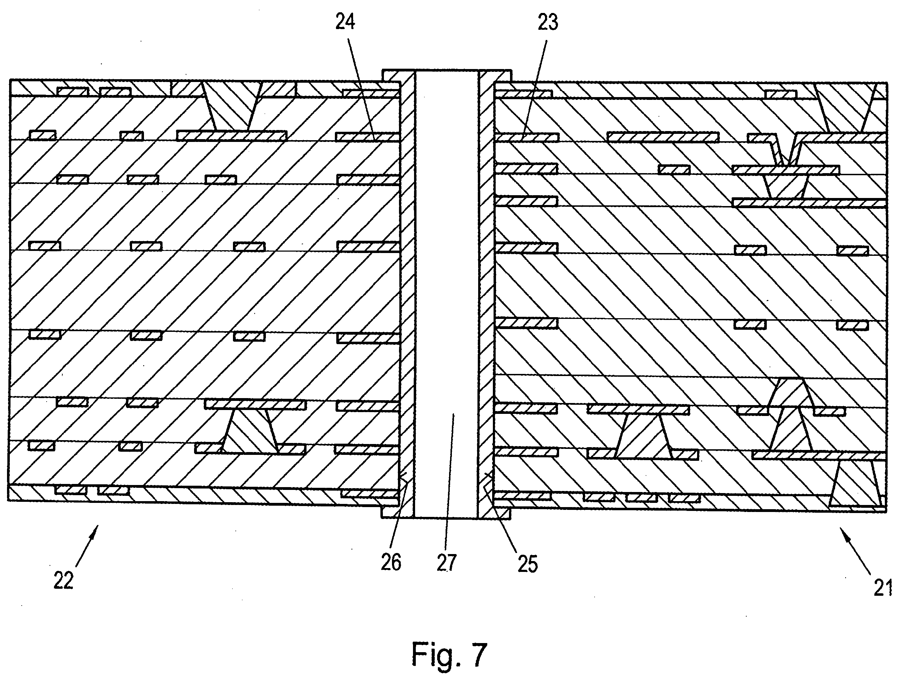

In Fig. 7 ist in größerem Detail und in größerem Maßstab ein Teilbereich von miteinander zu verbindenden Leiterplattenbereichen 21 und 22 dargestellt, wobei ersichtlich ist, dass beide Leiterplattenbereiche 21 und 22 eine Vielzahl von insbesondere in unterschiedlichen Ebenen bzw. Höhen liegenden Schichten bzw. Lagen aufweisen, wobei darüber hinaus schematisch jeweils strukturierte leitende Elemente bzw. Verbindungsanschlüsse 23 und 24 angedeutet sind.

Im Bereich von aneinander angrenzenden Seitenflächen 25, 26 der miteinander zu verbindenden Leiterplattenbereiche 21 und 22 ist ein Hohlraum bzw. Schlitz 27 angedeutet, welcher beispielsweise wiederum ähnlich der Ausführungsform gemäß Fig. 3 mit einem leitenden bzw. leitfähigen Material, beispielsweise mit Kupfer für eine elektrische Kopplung einzelner leitender Teilbereiche von miteinander zu verbindenden Lagen zu verfüllen ist.

Bei Ausbilden der elektrisch leitenden Verbindung jeweils lediglich über einen Teilbereich der Dicke bzw. Höhe der miteinander zu verbindenden Leiterplattenbereiche 21, 22 können somit unmittelbar unterschiedliche leitende Strukturen in unterschiedlicher Höhe der miteinander zu verbindenden Leiterplattenbereiche 21, 22 miteinander elektrisch gekoppelt bzw. verbunden werden.

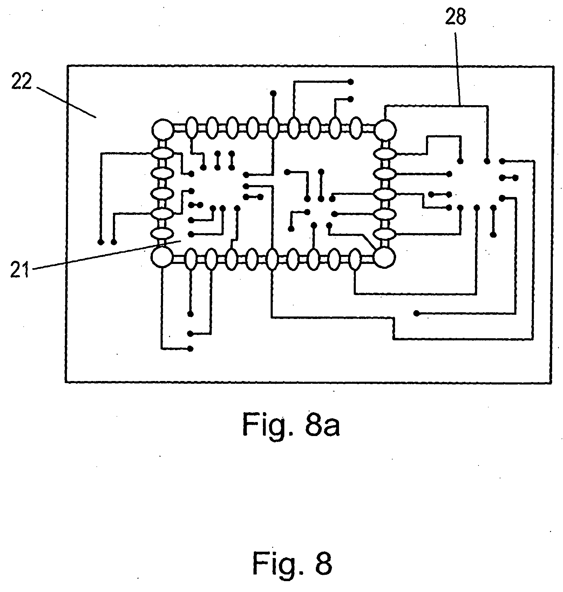

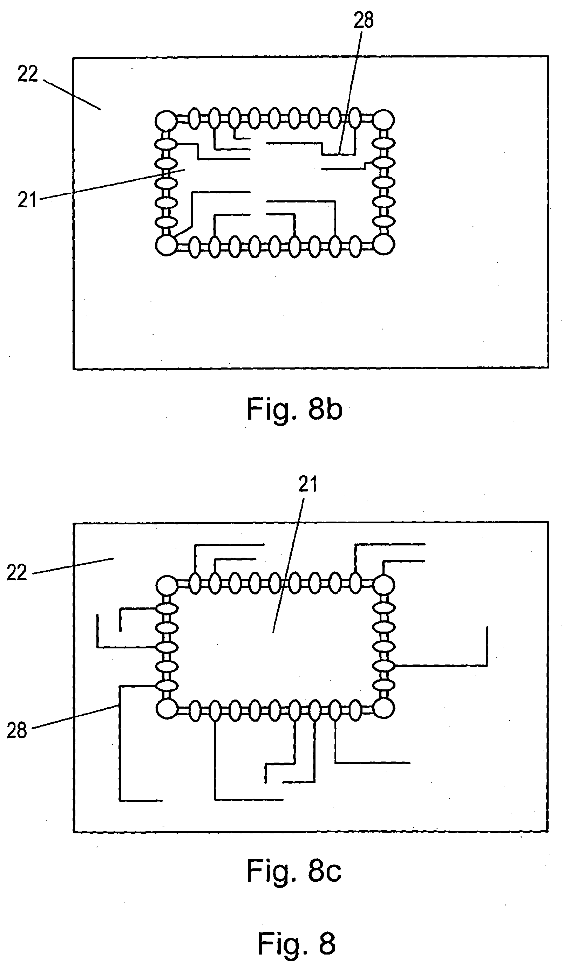

Eine derartige Kopplung unterschiedlicher Teilbereiche bzw. Lagen der miteinander zu verbindenden Leiterplattenbereiche über jeweils eine Mehrzahl von elektrischen Verbindungen ist schematisch in Fig. 8a, 8b und 8c dargestellt. Hierbei ist in Fig. 8a angedeutet, wie an einer Mehrzahl von mit 28 bezeichneten Positionen bzw. Stellen einer elektrischen Verbindung bzw. Kopplung beispielsweise die in einer obersten Schicht bzw. Lage der in Fig. 7 dargestellten, zu verbindenden Leiterplattenbereiche 21 und 22 vorgesehenen leitenden Strukturen gekoppelt werden.

Demgegenüber zeigt Fig. 8b schematisch eine elektrische Verbindung bzw. Kopplung von anderen leitenden Strukturen des innenliegenden Leiterplattenbereichs 22, während Fig. 8c leitende Strukturen für den äußeren Leiterplattenbereich 21 zeigt, wobei jeweils wiederum mit 28 bezeichnete elektrische Verbindungen vorgesehen sind.

In Fig. 9 ist ähnlich der Darstellung zu Fig. 5d eine abgewandelte Ausführungsform einer Verbindung von miteinander zu verbindenden Leiterplattenbereichen 1 und 2 gezeigt, wobei zu einer Erzielung einer gewünschten mechanischen Kopplung im Bereich der zueinander komplementären Kopplungselemente 16 ein Kleber zum Einsatz gelangt, wie dies durch 34 angedeutet ist. Derart kann insbesondere eine blasenfreie Verfüllung mit dem Kleber im Bereich der zueinander komplementären Kopplungsstellen 16 zur Verfügung gestellt werden.

Bei den in Fig. 10 dargestellten Verfahrensschritten ist ersichtlich, dass die miteinander zu verbindenden Leiterplattenbereiche 1 und 2 unterschiedliche Höhe bzw. Dicke aufweisen. Für einen Höhenausgleich zur Bereitstellung einer im Wesentlichen ebenen bzw. vollflächigen Oberfläche, welche nachfolgende Be- bzw. Verarbeitungsschritte erleichtert bzw. hierfür erforderlich ist, ist in Fig. 10a dargestellt, dass die miteinander zu verbindenden Leiterplattenbereiche auf einer Abstütz- bzw. Supportschicht 42, beispielsweise einem Klebeband angeordnet werden, woran anschließend eine Laminierung mit einem mehrlagigen Laminat 35 vorgenommen wird, wobei das Laminat 35 wenigstens eine isolierende Schicht 36, beispielsweise ein Prepreg aufweist, welche zu den miteinander zu verbindenden Leiterplattenbereichen 1 und 2 gewandt ist. Darüber hinaus weist das Laminat 35 eine beispielsweise von einer Kupferfolie gebildete leitende Schicht 37 auf.

Bei der in Fig. 10a dargestellten Ausführungsform wird zum Ausgleich der vergleichsweise großen Unterschiede in der Dicke bzw. Höhe der miteinander zu verbindenden Leiterplattenbereiche 1 und 2 ein zusätzliches, auf die Abmessungen des die geringere Höhe aufweisenden Leiterplattenbereichs 1 abgestimmtes isolierendes Material 38 eingesetzt, welches ähnlich wie die Schicht 36 von einem Prepreg gebildet wird.

Bei einem Laminieren des Laminats 35 sowie des zusätzlichen Prepreg-Elements 38 mit den miteinander zu verbindenden und auf der Abstützschicht 42 abgestützten Leiterplattenbereichen 1 und 2 entsprechend dem Pfeil 39 erfolgt nicht nur eine Verbindung mit den zu dem Prepreg-Material 36 bzw. 38 gewandten Oberflächen der miteinander zu verbindenden Leiterplattenbereiche 1 und 2, sondern auch ein teilweises Verfüllen des Spalts zwischen den zueinander gewandten Seitenflächen 3, wie dies in Fig. 10b angedeutet ist.

Bei dem in Fig. 10b dargestellten Verfahrensschritt erfolgt nach einem Laminieren mit dem Laminat 35 entsprechend dem in Fig. 10a dargestellten Verfahrensschritt und nach einem Entfernen der Abstützschicht 42 eine weitere Laminierung mit einem ebenfalls von einem Prepreg 36 und einer leitenden Schicht 37 gebildeten mehrlagigen Laminat 35, wie dies durch den Pfeil 40 angedeutet ist.

Zur nachfolgenden Herstellung der elektrisch leitenden Verbindungen unterschiedlicher leitender Teilbereiche bzw. Anschlüsse in den miteinander zu verbindenden Leiterplattenbereichen 1 und 2, welche der Einfachheit halber in der Darstellung von Fig. 10 nicht näher gezeigt sind, erfolgt beispielsweise durch Bohrvorgänge, wie dies durch die Pfeile 41 angedeutet ist, eine Ausbildung von Bohrungen und ein nachträgliches Verfüllen mit einem leitenden bzw. leitfähigen Material, wie dies im Zusammenhang mit vorangehenden Ausführungsformen mehrfach erörtert und dargestellt wurde.

Eine mechanische Kopplung bzw. Verbindung der miteinander zu verbindenden Leiterplattenbereiche 1, 2 bzw. 21 und 22 kann beispielsweise durch ein Kleben, Presspassen, Laminieren, Bonden, Schweißen, Löten oder eine galvanische Verbindung vorgenommen werden.

Darüber hinaus kann sowohl eine mechanische als auch eine elektrische Verbindung bzw. Kopplung zwischen miteinander zu verbindenden Leiterplattenbereichen 1 und 2 bzw. 21 und 22 derart ausgebildet sein, dass die miteinander zu verbindenden Leiterplattenbereiche 1 und 2 bzw. 21 und 22 beispielsweise lediglich an einer aneinander angrenzenden Seitenfläche miteinander verbunden werden, während bei den obigen Ausführungsformen jeweils ein Leiterplattenbereich im Wesentlichen vollständig von einem weiteren Leiterplattenbereich über seinen gesamten Umfang umgeben wird.

Wie oben bereits ausgeführt, ist es möglich, eine Vielzahl von unterschiedlichen Leiterplatten bzw. Leiterplattenbereichen miteinander zu verbinden, wobei die Leiterplattenbereiche 1, 2, 21 bzw. 22 beispielsweise von flexiblen, starren, starr-flexiblen oder semi-flexiblen Leiterplattenbereichen gebildet sein können. Zusätzlich oder alternativ können auch funktionell unterschiedliche Materialien, wie beispielsweise Hochfrequenz-, HDI-, Substrat- oder keramische Leiterplattenbereiche für eine Kopplung vorgesehen sein.

## Patentansprüche

1. Verfahren zum Herstellen einer aus wenigstens zwei Leiterplattenbereichen (1, 2, 21, 22) bestehenden Leiterplatte, wobei die Leiterplattenbereiche (1, 2, 21, 22) jeweils wenigstens eine leitende Schicht, insbesondere strukturierte leitende Schicht und/oder wenigstens einen Bauteil oder eine leitende Komponente beinhalten, wobei miteinander zu verbindende Leiterplattenbereiche (1, 2, 21, 22) im Bereich von jeweils wenigstens einer unmittelbar aneinander angrenzenden Seitenfläche (3, 25, 26) miteinander durch eine mechanische Kopplung bzw. Verbindung verbunden werden, wobei jeweils wenigstens ein Teilbereich oder Verbindungsanschluss (23, 24) der wenigstens einen leitenden Schicht (31) und/oder ein leitendes Element (33) des Bauteils (32) bzw. der Komponente der miteinander mechanisch verbundenen bzw. zu verbindenden Leiterplattenbereiche (1, 2, 21, 22) an der wenigstens einen aneinander angrenzenden Seitenfläche (3, 25, 26) elektrisch leitend miteinander verbunden bzw. gekoppelt werden, **dadurch gekennzeichnet, dass** die eine unterschiedliche Höhe bzw. Dicke aufweisenden Leiterplattenbereiche (1, 2) wenigstens auf der unterschiedlich hohe Bereiche aufweisenden Oberfläche mit einem wenigstens eine zu den Leiterplattenbereichen gewandte isolierende Schicht (36) und eine leitende Schicht (37) aufweisenden Laminat (35) unter wenigstens teilweiser Verfüllung des Spalts an den aneinander angrenzenden Seitenflächen (3) laminiert werden und nachfolgend die elektrisch leitende Verbindung von elektrisch leitenden Teilbereichen oder Verbindungsanschlüssen an den aneinander angrenzenden Seitenflächen (3) ausgebildet wird.

2. Verfahren nach Anspruch 1, **dadurch gekennzeichnet, dass** die Leiterplattenbereiche (1, 2) auf beiden Oberflächen mit einem mehrlagigen Laminat (35) laminiert werden.

3. Verfahren nach Anspruch 1 oder 2, **dadurch gekennzeichnet, dass** die miteinander zu verbindenden Teilbereiche oder Verbindungsanschlüsse (23, 24) der wenigstens einen leitenden Schicht (31) und/oder des leitenden Elements (33) des Bauteils (22) bzw. der Komponente zur Ausbildung der elektrischen Verbindung (5, 6, 7, 9, 11, 13, 14, 15, 16, 17, 18, 19, 20, 28) durch Anordnung eines leitenden Materials elektrisch miteinander verbunden bzw. gekoppelt werden.

4. Verfahren nach Anspruch 1, 2 oder 3, **dadurch gekennzeichnet, dass** zur Ausbildung der elektrisch leitenden Verbindung (5, 6, 7, 9, 11, 13, 14, 15, 16, 17, 18, 19, 20, 28) ein elektrisch leitendes Metall, wie beispielsweise Kupfer, oder ein wenigstens eine leitende bzw. leitfähige Komponente enthaltendes Material, wie beispielsweise eine Kupfer enthaltende Paste verwendet wird.

5. Verfahren nach einem der Ansprüche 1 bis 4, **dadurch gekennzeichnet, dass** elektrisch leitende Schichten (23, 24, 31, 33) in unterschiedlichen Höhen bzw. Ebenen der miteinander zu verbindenden Leiterplattenbereiche (1, 2, 21, 22) leitend miteinander verbunden bzw. gekoppelt werden.

6. Verfahren nach einem der Ansprüche 1 bis 5, **dadurch gekennzeichnet, dass** eine unterschiedliche Anzahl von Schichten (23, 24, 31, 33) und/oder nicht aufeinander abgestimmte Schichten miteinander verbunden bzw. gekoppelt wird bzw. werden.

7. Verfahren nach einem der Ansprüche 1 bis 6, **dadurch gekennzeichnet, dass** die elektrisch leitende Verbindung (28) über einen Teilbereich der Höhe der miteinander zu verbindenden Leiterplattenbereiche (21, 22) ausgebildet wird.

8. Verfahren nach einem der Ansprüche 1 bis 7, **dadurch gekennzeichnet, dass** eine Mehrzahl von elektrisch leitenden Verbindungen bzw. Kopplungen (5, 6, 7, 9, 11, 19, 28) voneinander getrennt entlang der wenigstens einen aneinander angrenzenden Seitenfläche (3, 25, 26) der miteinander zu verbindenden Leiterplattenbereiche (1, 2, 21, 22) ausgebildet wird.

9. Verfahren nach einem der Ansprüche 1 bis 8, **dadurch gekennzeichnet, dass** Durchbrechungen oder Hohlräume (4, 27) in dem Spalt zwischen aneinander angrenzenden Seitenflächen (3, 25, 26) zur Ausbildung der elektrisch leitenden Verbindungen (5, 6, 7, 9, 11, 13, 14, 15, 16, 17, 18, 19, 20, 28) durch ein Bohrverfahren, insbesondere ein mechanisches Bohren oder ein Laserbohren, oder durch ein Photoresistverfahren hergestellt werden.

10. Verfahren nach Anspruch 9, **dadurch gekennzeichnet, dass** die elektrisch leitende Verbindung (5, 6, 7) durch ein Plattieren oder Füllen der Durchbrechungen bzw. Hohlräume (4) mit einem leitenden Metall, insbesondere Kupfer, oder durch eine Anordnung von stiftartigen Elementen aus einem leitenden Material gebildet wird.

11. Verfahren nach einem der Ansprüche 1 bis 8, **dadurch gekennzeichnet, dass** der Spalt (4) zwischen aneinander angrenzenden Seitenflächen (3) mit einem leitenden bzw. leitfähigen Material gefüllt wird und dass nach dem Füllen des Spalts mit leitendem bzw. leitfähigem Material Teilbereiche desselben durch eine Ausbildung von Durchbrechungen (12) oder dgl. und gegebenenfalls nachträgliches Füllen mit isolierenden Material zur Ausbildung von voneinander getrennten Kontaktierungen (11) voneinander getrennt werden.

12. Verfahren nach einem der Ansprüche 1 bis 11, **dadurch gekennzeichnet, dass** miteinander zu verbindende Leiterplattenbereiche (1, 2, 21, 22) im Wesentlichen in einer gemeinsamen Ebene angeordnet und miteinander verbunden bzw. gekoppelt werden.

13. Verfahren nach einem der Ansprüche 1 bis 12, **dadurch gekennzeichnet, dass** die mechanische Kopplung bzw. Verbindung der miteinander zu verbindenden Leiterplattenbereiche (1, 2, 21, 22) in an sich bekannter Weise durch ein Kleben, Presspassen, Laminieren, Bonden, Schweißen, Löten oder eine galvanische Verbindung vorgenommen wird.

14. Verfahren nach einem der Ansprüche 1 bis 13, **dadurch gekennzeichnet, dass** eine provisorische mechanische Kopplung bzw. Verbindung der miteinander zu verbindenden Leiterplattenbereiche (1, 2, 21, 22) durch eine Verwendung eines Füllmaterials, durch ein Kleben, durch ein Presspassen, durch Verwendung eines Trägers, wie beispielsweise eines anhaftenden Bands, oder dgl. durchgeführt wird.

15. Verfahren nach einem der Ansprüche 1 bis 14, **dadurch gekennzeichnet, dass** an aneinander angrenzenden Seitenflächen (3) der miteinander zu verbindenden Leiterplattenbereiche (1, 2) in an sich bekannter Weise jeweils wenigstens ein zueinander komplementäres Kopplungselement (16) ausgebildet wird, über welches eine Kopplung bzw. Verbindung mit dem jeweils angrenzenden Leiterplattenbereich vorgenommen wird.

16. Verfahren nach Anspruch 15, **dadurch gekennzeichnet, dass** zueinander komplementäre Kopplungselemente (16) formschlüssig miteinander verbunden werden.

17. Verfahren nach Anspruch 14 oder 15, **dadurch gekennzeichnet, dass** die mechanische Kopplung bzw. Verbindung durch Verwendung eines Klebers (34) im Bereich der zueinander komplementären Kopplungselemente (16) ausgebildet wird.

18. Verfahren nach einem der Ansprüche 1 bis 17, **dadurch gekennzeichnet, dass** die miteinander zu verbindenden Leiterplattenbereiche (1, 2, 21, 22) in an sich bekannter Weise von flexiblen, starren, starr-flexiblen oder semi-flexiblen Leiterplattenbereichen und/oder funktionell unterschiedlichen Materialien, beinhaltend Hochfrequenz-, HDI-, Substrat-, oder keramischen Leiterplattenbereichen gebildet werden.

19. Leiterplatte, bestehend aus wenigstens zwei Leiterplattenbereichen (1, 2, 21, 22), wobei die Leiterplattenbereiche (1, 2, 21, 22) jeweils wenigstens eine leitende Schicht, insbesondere strukturierte leitende Schicht und/oder wenigstens einen Bauteil oder eine leitende Komponente beinhalten, wobei miteinander zu verbindende Leiterplattenbereiche (1, 2, 21, 22) im Bereich von jeweils wenigstens einer unmittelbar aneinander angrenzenden Seitenfläche (3, 25, 26) miteinander durch eine mechanische Kopplung bzw. Verbindung verbunden sind, wobei eine elektrisch leitende Kopplung bzw. Verbindung (5, 6, 7, 9, 11, 13, 14, 15, 16, 17, 18, 19, 20, 28) zwischen wenigstens einem Teilbereich oder Verbindungsanschluss (23, 24) der wenigstens einen leitenden Schicht (31) und/oder einem leitenden Element (33) des Bauteils (32) bzw. der Komponente der miteinander mechanisch verbundenen bzw. zu verbindenden Leiterplattenbereiche (1, 2, 21, 22) an der wenigstens einen aneinander angrenzenden Seitenfläche (3, 25, 26) vorgesehen bzw. ausgebildet ist, **dadurch gekennzeichnet, dass** die eine unterschiedliche Höhe bzw. Dicke aufweisenden Leiterplattenbereiche (1, 2) wenigstens auf der unterschiedlich hohe Bereiche aufweisenden Oberfläche mit einem wenigstens eine zu den Leiterplattenbereichen gewandte isolierende Schicht (36) und eine leitende Schicht (37) aufweisenden Laminat (35) unter wenigstens teilweiser Verfüllung des Spalts an den aneinander angrenzenden Seitenflächen (3) laminiert sind.

20. Leiterplatte nach Anspruch 19, **dadurch gekennzeichnet, dass** die Leiterplattenbereiche (1, 2) auf beiden Oberflächen mit einem mehrlagigen Laminat (35) laminiert sind.

21. Leiterplatte nach Anspruch 19 oder 20, **dadurch gekennzeichnet, dass** zur Ausbildung der elektrischen Verbindung (5, 6, 7, 9, 11, 13, 14, 15, 16, 17, 18, 19, 20, 28) ein leitendes Material im Bereich der miteinander zu verbindenden Teilbereiche oder Verbindungsanschlüsse (23, 24) der wenigstens einen leitenden Schicht (31) und/oder des leitenden Elements (33) des Bauteils (32) bzw. der Komponente vorgesehen ist.

22. Leiterplatte nach Anspruch 19, 20 oder 21, **dadurch gekennzeichnet, dass** zur Ausbildung der elektrisch leitenden Verbindung (5, 6, 7, 9, 11, 13, 14, 15, 16, 17, 18, 19, 20, 28) ein elektrisch leitendes Metall, wie beispielsweise Kupfer, oder ein wenigstens eine leitende bzw. leitfähige Komponente enthaltendes Material, wie beispielsweise eine Kupfer enthaltende Paste vorgesehen ist.

23. Leiterplatte nach einem der Ansprüche 19 bis 22, **dadurch gekennzeichnet, dass** elektrisch leitende Schichten (23, 24, 31, 33) in unterschiedlichen Höhen bzw. Ebenen der miteinander zu verbindenden Leiterplattenbereiche (1, 2, 21, 22) leitend miteinander verbunden bzw. gekoppelt sind.

24. Leiterplatte nach einem der Ansprüche 19 bis 23, **dadurch gekennzeichnet, dass** eine unterschiedliche Anzahl von Schichten (23, 24, 31, 33) und/oder nicht aufeinander abgestimmte Schichten miteinander verbunden bzw. gekoppelt ist bzw. sind.

25. Leiterplatte nach einem der Ansprüche 19 bis 24, **dadurch gekennzeichnet, dass** die elektrisch leitende Verbindung (28) über einen Teilbereich der Höhe der miteinander zu verbindenden Leiterplattenbereiche (21, 22) ausgebildet ist.

26. Leiterplatte nach einem der Ansprüche 19 bis 25, **dadurch gekennzeichnet, dass** eine Mehrzahl von elektrisch leitenden Verbindungen bzw. Kopplungen (5, 6, 7, 9, 11, 19, 28) voneinander getrennt entlang der wenigstens einen aneinander angrenzenden Seitenfläche (3, 25, 26) der miteinander zu verbindenden Leiterplattenbereiche (1, 2, 21, 22) ausgebildet ist.

27. Leiterplatte nach einem der Ansprüche 19 bis 26, **dadurch gekennzeichnet, dass** Durchbrechungen oder Hohlräume (4, 27) in dem Spalt zwischen aneinander angrenzenden Seitenflächen (3, 25, 26) zur Ausbildung der elektrisch leitenden Verbindungen (5, 6, 7, 9, 11, 13, 14, 15, 16, 17, 18, 19, 20, 28) oder zur Trennung von elektrisch leitenden Teilbereichen bzw. Kontaktierungen vorgesehen sind.

28. Leiterplatte nach Anspruch 27, **dadurch gekennzeichnet, dass** die elektrisch leitende Verbindung (5, 6, 7) durch ein Plattieren oder Füllen der Durchbrechungen bzw. Hohlräume (4) mit einem leitenden Metall, insbesondere Kupfer, oder durch stiftartige Elemente aus einem leitenden Material gebildet ist.

29. Leiterplatte nach einem der Ansprüche 19 bis 28, **dadurch gekennzeichnet, dass** miteinander zu verbindende Leiterplattenbereiche (1, 2, 21, 22) im Wesentlichen in einer gemeinsamen Ebene angeordnet und miteinander verbunden bzw. gekoppelt sind.

30. Leiterplatte nach einem der Ansprüche 19 bis 29, **dadurch gekennzeichnet, dass** die mechanische Kopplung bzw. Verbindung der miteinander zu verbindenden Leiterplattenbereiche (1, 2, 21, 22) in an sich bekannter Weise durch ein Kleben, Presspassen, Laminieren, Bonden, Schweißen, Löten oder eine galvanische Verbindung ausgebildet ist.

31. Leiterplatte nach einem der Ansprüche 19 bis 30, **dadurch gekennzeichnet, dass** eine provisorische mechanische Kopplung bzw. Verbindung der miteinander zu verbindenden Leiterplattenbereiche (1, 2, 21, 22) durch eine Verwendung eines Füllmaterials, durch ein Kleben, durch ein Presspassen, durch Verwendung eines Trägers, wie beispielsweise eines anhaftenden Bands, oder dgl. vorgesehen ist.

32. Leiterplatte nach einem der Ansprüche 19 bis 31, **dadurch gekennzeichnet, dass** an aneinander angrenzenden Seitenflächen (3) der miteinander zu verbindenden Leiterplattenbereiche (1, 2) in an sich bekannter Weise jeweils wenigstens ein zueinander komplementäres Kopplungselement (16) vorgesehen ist, über welches eine Kopplung bzw. Verbindung mit dem jeweils angrenzenden Leiterplattenbereich ausgebildet ist.

33. Leiterplatte nach Anspruch 32, **dadurch gekennzeichnet, dass** zueinander komplementäre Kopplungselemente (16) formschlüssig miteinander verbindbar sind.

34. Leiterplatte nach Anspruch 32 oder 33, **dadurch gekennzeichnet, dass** die mechanische Kopplung bzw. Verbindung durch Verwendung eines Klebers (34) im Bereich der zueinander komplementären Kopplungselemente (16) ausgebildet ist.

35. Leiterplatte nach einem der Ansprüche 19 bis 34, **dadurch gekennzeichnet, dass** die miteinander zu verbindenden Leiterplattenbereiche (1, 2, 21, 22) in an sich bekannter Weise von flexiblen, starren, starr-flexiblen oder semi-flexiblen Leiterplattenbereichen und/oder funktionell unterschiedlichen Materialien, beinhaltend Hochfrequenz-, HDI-, Substrat-, oder keramischen Leiterplattenbereichen gebildet sind.

36. Leiterplatte nach einem der Ansprüche 19 bis 35, **dadurch gekennzeichnet, dass** die miteinander zu verbindenden Leiterplattenbereiche (1, 2) mit wenigstens einer Markierung (17, 18), insbesondere einem Stift oder dgl. zur Registrierung bei der Verbindung miteinander ausgebildet sind.

## Claims

1. A method for producing a printed circuit board consisting of at least two printed circuit board regions (1, 2, 21, 22), wherein the printed circuit board regions (1, 2, 21, 22) each comprise at least one conductive layer, in particular a structured conductive layer, and/or at least one device or conductive component, wherein printed circuit board regions (1, 2, 21, 22) to be connected to one another, in the region of in each case at least one lateral surface (3, 25, 26) directly adjoining one another, are connected to one another by a mechanical coupling or connection, wherein at least one subregion or connection port (23, 24) of the at least one conductive layer (31) and/or a conductive element (33) of the device (32) or component of the printed circuit board regions (1, 2, 21, 22) mechanically connected or to be mechanically connected to one another are electrically conductively connected or coupled to each other on the at least one lateral surface (3, 25, 26) adjoining one another, **characterized in that** the printed circuit board regions (1, 2) having different heights or thicknesses are laminated, at least on the surfaces having differently high regions, with a laminate (35) comprising at least one insulating layer (36) facing the printed circuit board regions and a conducting layer (37), while at least partially filling the gap on the mutually adjoining side faces (3), and after this the electrically conducting connection of electrically conductive subregions or connection ports is formed on the mutually adjoining side faces (3).

2. A method according to claim 1, **characterized in that** the printed circuit board regions (1, 2) are laminated with a multilayer laminate (35) on both surfaces.

3. A method according to claim 1 or 2, **characterized in that** the subregions or connection ports (23, 24) to be connected to one another of the at least one conducting layer (31) and/or the conductive element (33) of the device (22) or component are electrically connected or coupled to one another by providing a conductive material for forming the electrical connection (5, 6, 7, 9, 11, 13, 14, 15, 16, 17, 18, 19, 20, 28).

4. A method according to claim 1, 2 or 3, **characterized in that** an electrically conducting metal such as copper, or a material containing at least one conducting or conductive component such as a copper-containing paste, is used for forming the electrically conductive connection (5, 6, 7, 9, 11, 13, 14, 15, 16, 17, 18, 19, 20, 28).

5. A method according to any one of claims 1 to 4, **characterized in that** electrically conducting layers (23, 24, 31, 33) are conductively connected or coupled to one another in different levels or planes of the printed circuit board regions (1, 2, 21, 22) to be connected to one another.

6. A method according to any one of claims 1 to 5, **characterized in that** a different number of layers (23, 24, 31, 33), and/or layers that are not adjusted to one another, are connected or coupled to one another.

7. A method according to any one of claims 1 to 6, **characterized in that** the electrically conductive connection (28) is formed over a portion of the height of the printed circuit board regions (21, 22) to be connected to one another.

8. A method according to any one of claims 1 to 7, **characterized in that** a plurality of electrically conductive connections or couplings (5, 6, 7, 9, 11, 13, 14, 15, 16, 17, 18, 19, 20, 28) are mutually separately formed along the at least one side face (3, 25, 26) adjoining one another, of the printed circuit board regions (1, 2, 21, 22) to be connected to one another.

9. A method according to any one of claims 1 to 8, **characterized in that** passages or cavities (4, 27) are provided in the gap between mutually adjoining side faces (3, 25, 26) for forming the electrically conductive connections (5, 6, 7, 9, 11, 13, 14, 15, 16, 17, 18, 19, 20, 28) by a drilling process, in particular mechanical drilling or laser drilling, or by a photoresist process.

10. A method according to claim 9, **characterized in that** the electrically conductive connection (5, 6, 7) is formed by plating or filling the passages or cavities (4) with a conducting metal, in particular copper, or by arranging pin-like elements made of conducting material.

11. A method according to any one of claims 1 to 8, **characterized in that** the gap (4) between mutually adjoining side faces (3) is filled with a conductive or conducting material, and that, after having filled the gap with conductive or conducting material, subregions of the same are separated from one another by forming passages (12) or the like and, optionally, subsequent filling with insulating material for forming mutually separated contact-connections (11).

12. A method according to any one of claims 1 to 11, **characterized in that** printed circuit board regions (1, 2, 21, 22) to be connected to one another are substantially arranged in a common plane and connected or coupled to one another.

13. A method according to any one of claims 1 to 12, **characterized in that** the mechanical coupling or connection of the printed circuit board regions (1, 2, 21, 22) to be connected to one another in a manner known per se is performed by gluing, press-fitting, laminating, bonding, welding, soldering, or by a galvanic connection.

14. A method according to any one of claims 1 to 13, **characterized in that** a provisional mechanical coupling or connection of the printed circuit board regions (1, 2, 21, 22) to be connected to one another is provided by using a filler material, by gluing or bonding, by press-fitting, by using a substrate such as an adhesive tape, or the like.

15. A method according to any one of claims 1 to 14, **characterized in that** at least one mutually complementary coupling element (16) is each formed, in a manner known per se, on mutually adjoining side faces (3) of the printed circuit board regions (1, 2) to be connected to one another, via which coupling element a coupling or connection to the respectively adjoining printed circuit board region is realized.

16. A method according to claim 15, **characterized in that** mutually complementary coupling elements (16) are connected to each other in a form-fitting manner.

17. A method according to claim 14 or 15, **characterized in that** the mechanical coupling or connection is formed by using an adhesive (34) in the region of the mutually complementary coupling elements (16).

18. A method according to any one of claims 1 to 17, **characterized in that** the printed circuit board regions (1, 2, 21, 22) to be connected to one another in a manner known per se are comprised of flexible, rigid, rigid-flexible, or semi-flexible printed circuit board regions, and/or of functionally different materials including high-frequency, HDI, substrate or ceramic printed circuit board regions.

19. A printed circuit board consisting of at least two printed circuit board regions (1, 2, 21, 22), wherein the printed circuit board regions (1, 2, 21, 22) each comprise at least one conductive layer, in particular a structured conductive layer, and/or at least one device or conductive component, wherein printed circuit board regions (1, 2, 21, 22) to be connected to one another, in the region of in each case at least one lateral surface (3, 25, 26) directly adjoining one another, are connected to one another by a mechanical coupling or connection, wherein an electrically conductive coupling or connection (5, 6, 7, 9, 11, 13, 14, 15, 16, 17, 18, 19, 20, 28) is provided or formed between at least one subregion or connection port (23, 24) of the at least one conductive layer (31) and/or a conductive element (33) of the device (32) or component of the printed circuit board regions (1, 2, 21, 22) mechanically connected or to be mechanically connected to one another, on the at least one lateral surface (3, 25, 26) adjoining one another, **characterized in that** the printed circuit board regions (1, 2) having different heights or thicknesses are laminated, at least on the surfaces having differently high regions, with a laminate (35) comprising at least one insulating layer (36) facing the printed circuit board regions and a conducting layer (37), while at least partially filling the gap on the mutually adjoining side faces (3).

20. A printed circuit board according to claim 19, **characterized in that** the printed circuit board regions (1, 2) are laminated with a multilayer laminate (35) on both surfaces.

21. A printed circuit board according to claim 19 or 20, **characterized in that** for the formation of the electrical connection (5, 6, 7, 9, 11, 13, 14, 15, 16, 17, 18, 19, 20, 28) a conductive material is provided in the region of the subregions or connection ports (23, 24) to be connected to one another, of the at least one conducting layer (31) and/or conductive element (33) of the device (32) or component.

22. A printed circuit board according to claim 19, 20 or 21, **characterized in that** for the formation of the electrically conductive connection (5, 6, 7, 9, 11, 13, 14, 15, 16, 17, 18, 19, 20, 28) an electrically conducting metal such as copper, or a material containing at least one conducting or conductive component such as a copper-containing paste, is provided.

23. A printed circuit board according to any one of claims 19 to 22, **characterized in that** electrically conducting layers (23, 24, 31, 33) are conductively connected or coupled to one another in different levels or planes of the printed circuit board regions (1, 2, 21, 22) to be connected to one another.

24. A printed circuit board according to any one of claims 19 to 23, **characterized in that** a different number of layers (23, 24, 31, 33), and/or layers that are not adapted to one another, are connected or coupled to one another.

25. A printed circuit board according to any one of claims 19 to 24, **characterized in that** the electrically conductive connection (28) is formed over a portion of the height of the printed circuit board regions (21, 22) to be connected to one another.

26. A printed circuit board according to any one of claims 19 to 25, **characterized in that** a plurality of electrically conductive connections or couplings (5, 6, 7, 9, 11, 19, 28) are mutually separately formed along the at least one side face (3, 25, 26) adjoining one another, of the printed circuit board regions (1, 2, 21, 22) to be connected to one another.

27. A printed circuit board according to any one of claims 19 to 26, **characterized in that** passages or cavities (4, 27) are provided in the gap between mutually adjoining side faces (3, 25, 26) for forming the electrically conductive connections (5, 6, 7, 9, 11, 13, 14, 15, 16, 17, 18, 19, 20, 28) or for separating electrically conducting subregions or contact-connections.

28. A printed circuit board according to claim 27, **characterized in that** the electrically conductive connection (5, 6, 7) is formed by plating or filling the passages or cavities (4) with a conducting metal, in particular copper, or by pin-like elements made of conducting material.

29. A printed circuit board according to any one of claims 19 to 28, **characterized in that** printed circuit board regions (1, 2, 21, 22) to be connected to one another are substantially arranged in a common plane and connected or coupled to one another.

30. A printed circuit board according to any one of claims 19 to 29, **characterized in that** the mechanical coupling or connection of the printed circuit board regions (1, 2, 21, 22) to be connected to one another in a manner known per se is formed by gluing, press-fitting, laminating, bonding, welding, soldering, or by a galvanic connection.

31. A printed circuit board according to any one of claims 19 to 30, **characterized in that** a provisional mechanical coupling or connection of the printed circuit board regions (1, 2, 21, 22) to be connected to one another is provided by using a filler material, by gluing or bonding, by press-fitting, by using a substrate such as an adhesive tape, or the like.

32. A printed circuit board according to any one of claims 19 to 31, **characterized in that** at least one mutually complementary coupling element (16) is each provided, in a manner known per se, on mutually adjoining side faces (3) of the printed circuit board regions (1, 2) to be connected to one another, via which coupling element a coupling or connection to the respectively adjoining printed circuit board region is formed.

33. A printed circuit board according to claim 32, **characterized in that** mutually complementary coupling elements (16) are connectable to each other in a form-fitting manner.

34. A printed circuit board according to claim 32 or 33, **characterized in that** the mechanical coupling or connection is formed by using an adhesive (34) in the region of the mutually complementary coupling elements (16).

35. A printed circuit board according to any one of claims 19 to 34, **characterized in that** the printed circuit board regions (1, 2, 21, 22) to be connected to one another in a manner known per se are comprised of flexible, rigid, rigid-flexible, or semi-flexible printed circuit board regions, and/or of functionally different materials including high-frequency, HDI, substrate or ceramic printed circuit board regions.

36. A printed circuit board according to any one of claims 19 to 35, **characterized in that** the printed circuit board regions (1, 2) to be connected to one another are formed with at least one marker (17, 18), in particular a pin or the like, for registration during connection.

## Revendications

1. Procédé de fabrication d'une carte à circuit imprimé constituée d'au moins deux régions de carte à circuit imprimé (1, 2, 21, 22), où les régions de carte à circuit imprimé (1, 2, 21, 22) contiennent respectivement au moins une couche conductrice, en particulier une couche conductrice structurée, et/ou au moins une pièce structurale ou un composant conducteur, où des régions de carte à circuit imprimé (1, 2, 21, 22) à relier entre elles sont reliées entre elles par un couplage ou une liaison mécanique dans la région respectivement d'au moins une face latérale (3, 25, 26) directement limitrophe des autres, où respectivement au moins une région partielle ou un raccord de liaison (23, 24) de la au moins une couche conductrice (31) et/ou un élément conducteur (33) de la pièce structurale (32) ou du composant des régions de carte à circuit imprimé (1, 2, 21, 22) reliées ou à relier entre elles mécaniquement sont reliés ou couplés entre eux de manière électroconductrice au niveau de la au moins une face latérale (3, 25, 26) limitrophe des autres, **caractérisé en ce que** les régions de carte à circuit imprimé (1, 2) présentant une hauteur ou une épaisseur différente sont laminées au moins sur la surface présentant des régions différemment hautes avec un laminé (35) comportant au moins une couche isolante (36) tournée vers les régions de carte à circuit imprimé et une couche conductrice (37) par le biais d'un remplissage au moins partiel de l'intervalle au niveau des faces latérales (3) limitrophes les unes des autres et ensuite la liaison électroconductrice est formée par des régions partielles ou des raccords de liaison électroconducteurs au niveau des faces latérales (3) limitrophes les unes des autres.

2. Procédé selon la revendication 1, **caractérisé en ce que** les régions de carte à circuit imprimé (1, 2) sont laminées sur les deux surfaces avec un laminé (35) à plusieurs couches.

3. Procédé selon la revendication 1 ou 2, **caractérisé en ce que** les régions partielles ou les raccords de liaison (23, 24) à relier entre eux de la au moins une couche conductrice (31) et/ou de l'élément conducteur (33) de la pièce structurale (22) ou du composant sont reliés ou couplés entre eux de manière électrique pour la formation de la liaison électrique (5, 6, 7, 9, 11, 13, 14, 15, 16, 17, 18, 19, 20, 28) par agencement d'un matériau conducteur.

4. Procédé selon la revendication 1, 2 ou 3, **caractérisé en ce que**, pour la formation de la liaison électroconductrice (5, 6, 7, 9, 11, 13, 14, 15, 16, 17, 18, 19, 20, 28), on utilise un métal électroconducteur, tel que par exemple du cuivre, ou un matériau contenant au moins un composant conducteur ou conductible, tel que par exemple une pâte contenant du cuivre.

5. Procédé selon l'une quelconque des revendications 1 à 4, **caractérisé en ce que** des couches électroconductrices (23, 24, 31, 33) sont reliées ou couplées entre elles de manière conductrice dans des hauteurs ou des plans différents des régions de carte à circuit imprimé (1, 2, 21, 22) à relier entre elles.

6. Procédé selon l'une quelconque des revendications 1 à 5, **caractérisé en ce qu'**un nombre différent de couches (23, 24, 31, 33) et/ou des couches non adaptées les unes aux autres sont reliées ou couplées entre elles.

7. Procédé selon l'une quelconque des revendications 1 à 6, **caractérisé en ce que** la liaison électroconductrice (28) est formée sur une région partielle de la hauteur des régions de carte à circuit imprimé (21, 22) à relier entre elles.

8. Procédé selon l'une quelconque des revendications 1 à 7, **caractérisé en ce qu'**une pluralité de liaisons ou de couplages électroconducteurs (5, 6, 7, 9, 11, 19, 28) sont formés séparés les uns des autres le long de la au moins une face latérale (3, 25, 26) limitrophe des autres des régions de carte à circuit imprimé (1, 2, 21, 22) à relier entre elles.

9. Procédé selon l'une quelconque des revendications 1 à 8, **caractérisé en ce que** des perçages ou des espaces creux (4, 27) sont fabriqués dans l'intervalle entre des faces latérales (3, 25, 26) limitrophes les unes des autres pour la formation des liaisons électroconductrices (5, 6, 7, 9, 11, 13, 14, 15, 16, 17, 18, 19, 20, 28) par un procédé de forage, en particulier un forage mécanique ou un forage à laser, ou par un procédé de photorésistance.

10. Procédé selon la revendication 9, **caractérisé en ce que** la liaison électroconductrice (5, 6, 7) est formée par placage ou remplissage des perçages ou des espaces creux (4) avec un métal conducteur, en particulier du cuivre, ou par un agencement d'éléments de type broche faits d'un matériau conducteur.

11. Procédé selon l'une quelconque des revendications 1 à 8, **caractérisé en ce que** l'intervalle (4) entre des faces latérales (3) limitrophes les unes des autres est rempli avec un matériau conducteur ou conductible et **en ce que**, après le remplissage de l'intervalle avec un matériau conducteur ou conductible, des régions partielles de l'intervalle sont séparées les unes des autres par une formation de perçages (12) ou similaire et, le cas échéant, un remplissage ultérieur avec un matériau isolant pour la formation de contacts (11) séparés les uns des autres.

12. Procédé selon l'une quelconque des revendications 1 à 11, **caractérisé en ce que** des régions de carte à circuit imprimé (1, 2, 21, 22) à relier entre elles sont disposées essentiellement dans un plan commun et reliées ou couplées entre elles.

13. Procédé selon l'une quelconque des revendications 1 à 12, **caractérisé en ce que** le couplage ou la liaison mécanique des régions de carte à circuit imprimé (1, 2, 21, 22) à relier entre elles est réalisé d'une manière connue en soi par un collage, une insertion avec ajustement serré, un laminage, un assemblage, un soudage, un brasage ou une liaison galvanique.

14. Procédé selon l'une quelconque des revendications 1 à 13, **caractérisé en ce qu'**un couplage ou une liaison mécanique provisoire des régions de carte à circuit imprimé (1, 2, 21, 22) à relier entre elles est exécuté par une utilisation d'un matériau de remplissage, par un collage, par une insertion avec ajustement serré, par utilisation d'un support, tel que par exemple un ruban adhésif, ou similaire.

15. Procédé selon l'une quelconque des revendications 1 à 14, **caractérisé en ce qu'**au niveau des faces latérales (3) limitrophes les unes des autres des régions de carte à circuit imprimé (1, 2) à relier entre elles est formé d'une manière connue en soi respectivement au moins un élément de couplage (16) complémentaire aux autres par le biais duquel est réalisé un couplage ou une liaison avec la région de carte à circuit imprimé limitrophe respective.

16. Procédé selon la revendication 15, **caractérisé en ce que** des éléments de couplage (16) complémentaires les uns aux autres sont reliés entre eux par conformité de forme.

17. Procédé selon la revendication 14 ou 15, **caractérisé en ce que** le couplage ou la liaison mécanique est formé par utilisation d'une colle (34) dans la région des éléments de couplage (16) complémentaires les uns aux autres.

18. Procédé selon l'une quelconque des revendications 1 à 17, **caractérisé en ce que** les régions de carte à circuit imprimé (1, 2, 21, 22) à relier entre elles sont formées d'une manière connue en soi par des régions de carte à circuit imprimé flexibles, rigides, fermement flexibles ou semi-flexibles et/ou par des matériaux fonctionnellement différents, contenant des régions de carte à circuit imprimé à haute fréquence, des régions de carte à circuit imprimé HDI, des régions de carte à circuit imprimé de substrat ou des régions de carte à circuit imprimé céramiques.

19. Carte à circuit imprimé, constituée au moins de deux régions de carte à circuit imprimé (1, 2, 21, 22), où les régions de carte à circuit imprimé (1, 2, 21, 22) contiennent respectivement au moins une couche conductrice, en particulier une couche conductrice structurée et/ou au moins une pièce structurale ou un composant conducteur, où des régions de carte à circuit imprimé (1, 2, 21, 22) à relier entre elles sont reliées entre elles par un couplage ou une liaison mécanique dans la région respectivement d'au moins une face latérale (3, 25, 26) directement limitrophe des autres, où un couplage électroconducteur ou une liaison électroconductrice (5, 6, 7, 9, 11, 13, 14, 15, 16, 17, 18, 19, 20, 28) est prévu ou formé entre au moins une région partielle ou un raccord de liaison (23, 24) de la au moins une couche conductrice (31) et/ou un élément conducteur (33) de la pièce structurale (32) ou du composant des régions de carte à circuit imprimé (1, 2, 21, 22) reliées ou à relier entre elles mécaniquement au niveau de la au moins une face latérale (3, 25, 26) limitrophe des autres, **caractérisée en ce que** les régions de carte à circuit imprimé (1, 2) présentant une hauteur ou une épaisseur différente sont laminées au moins sur la surface présentant des régions différemment hautes avec un laminé (35) comportant au moins une couche isolante (36) tournée vers les régions de carte à circuit imprimé et une couche conductrice (37) par le biais d'un remplissage au moins partiel de l'intervalle au niveau des faces latérales (3) limitrophes les unes des autres.

20. Carte à circuit imprimé selon la revendication 19, **caractérisée en ce que** les régions de carte à circuit imprimé (1, 2) sont laminées sur les deux surfaces avec un laminé (35) à plusieurs couches.

21. Carte à circuit imprimé selon la revendication 19 ou 20, **caractérisée en ce que**, pour la formation de la liaison électrique (5, 6, 7, 9, 11, 13, 14, 15, 16, 17, 18, 19, 20, 28), un matériau conducteur est prévu dans la région des régions partielles ou des raccords de liaison (23, 24) à relier entre eux de la au moins une couche conductrice (31) et/ou de l'élément conducteur (33) de la pièce structurale (32) ou du composant.

22. Carte à circuit imprimé selon la revendication 19, 20 ou 21, **caractérisée en ce que**, pour la formation de la liaison électroconductrice (5, 6, 7, 9, 11, 13, 14, 15, 16, 17, 18, 19, 20, 28), un métal électroconducteur, tel que par exemple du cuivre, ou un matériau contenant au moins un composant conducteur ou conductible, tel que par exemple une pâte contenant du cuivre, est prévu.

23. Carte à circuit imprimé selon l'une quelconque des revendications 19 à 22, **caractérisée en ce que** des couches électroconductrices (23, 24, 31, 33) sont reliées ou couplées entre elles de manière conductrice dans des hauteurs ou plans différents des régions de carte à circuit imprimé (1, 2, 21, 22) à relier entre elles.

24. Carte à circuit imprimé selon l'une quelconque des revendications 19 à 23, **caractérisée en ce qu'**un nombre différent de couches (23, 24, 31, 33) et/ou des couches non adaptées les unes aux autres sont reliées ou couplées entre elles.

25. Carte à circuit imprimé selon l'une quelconque des revendications 19 à 24, **caractérisée en ce que** la liaison électroconductrice (28) est formée sur une région partielle de la hauteur des régions de carte à circuit imprimé (21, 22) à relier entre elles.

26. Carte à circuit imprimé selon l'une quelconque des revendications 19 à 25, **caractérisée en ce qu'**une pluralité de liaisons ou de couplages électroconducteurs (5, 6, 7, 9, 11, 19, 28) sont formés séparés les uns des autres le long de la au moins une face latérale (3, 25, 26) limitrophe des autres des régions de carte à circuit imprimé (1, 2, 21, 22) à relier entre elles.

27. Carte à circuit imprimé selon l'une quelconque des revendications 19 à 26, **caractérisée en ce que** des perçages ou des espaces creux (4, 27) sont prévus dans l'intervalle entre des faces latérales (3, 25, 26) limitrophes les unes des autres pour la formation des liaisons électroconductrices (5, 6, 7, 9, 11, 13, 14, 15, 16, 17, 18, 19, 20, 28) ou pour la séparation de régions partielles ou de contacts électroconducteurs.

28. Carte à circuit imprimé selon la revendication 27, **caractérisée en ce que** la liaison électroconductrice (5, 6, 7) est formée par placage ou remplissage des perçages ou des espaces creux (4) avec un métal conducteur, en particulier du cuivre, ou par des éléments de type broche faits d'un matériau conducteur.

29. Carte à circuit imprimé selon l'une quelconque des revendications 19 à 28, **caractérisée en ce que** des régions de carte à circuit imprimé (1, 2, 21, 22) à relier entre elles sont disposées essentiellement dans un plan commun et reliées ou couplées entre elles.

30. Carte à circuit imprimé selon l'une quelconque des revendications 19 à 29, **caractérisée en ce que** le couplage ou la liaison mécanique des régions de carte à circuit imprimé (1, 2, 21, 22) à relier entre elles est formé d'une manière connue en soi par un collage, une insertion avec ajustement serré, un laminage, un assemblage, un soudage, un brasage ou une liaison galvanique.

31. Carte à circuit imprimé selon l'une quelconque des revendications 19 à 30, **caractérisée en ce qu'**un couplage ou une liaison mécanique provisoire des régions de carte à circuit imprimé (1, 2, 21, 22) à relier entre elles est prévu par une utilisation d'un matériau de remplissage, par un collage, par une insertion avec ajustement serré, par utilisation d'un support, tel que par exemple un ruban adhésif, ou similaire.

32. Carte à circuit imprimé selon l'une quelconque des revendications 19 à 31, **caractérisée en ce que**, au niveau des faces latérales (3) limitrophes les unes des autres des régions de carte à circuit imprimé (1, 2) à relier entre elles est prévu d'une manière connue en soi respectivement au moins un élément de couplage (16) complémentaire aux autres par le biais duquel est formé un couplage ou une liaison avec la région de carte à circuit imprimé limitrophe respective.

33. Carte à circuit imprimé selon la revendication 32, **caractérisée en ce que** des éléments de couplage (16) complémentaires les uns aux autres sont reliés entre eux par conformité de forme.

34. Carte à circuit imprimé selon la revendication 32 ou 33, **caractérisée en ce que** le couplage ou la liaison mécanique est formé par utilisation d'une colle (34) dans la région des éléments de couplage (16) complémentaires les uns aux autres.

35. Carte à circuit imprimé selon l'une quelconque des revendications 19 à 34, **caractérisée en ce que** les régions de carte à circuit imprimé (1, 2, 21, 22) à relier entre elles sont formées d'une manière connue en soi par des régions de carte à circuit imprimé flexibles, rigides, fermement flexibles ou semi-flexibles et/ou par des matériaux fonctionnellement différents, contenant des régions de carte à circuit imprimé à haute fréquence, des régions de carte à circuit imprimé HDI, des régions de carte à circuit imprimé de substrat ou des régions de carte à circuit imprimé céramiques.

36. Carte à circuit imprimé selon l'une quelconque des revendications 19 à 35, **caractérisée en ce que** les régions de carte à circuit imprimé (1, 2) à relier entre elles sont formées avec au moins un marquage (17, 18), en particulier une broche ou similaire, pour le repérage lors de leur liaison.
